(19) Europäisches Patentamt / European Patent Office / Office européen des brevets

(11) **EP 2 772 945 A1**

## (12) EUROPEAN PATENT APPLICATION
published in accordance with Art. 153(4) EPC

(43) Date of publication:
**03.09.2014 Bulletin 2014/36**

(21) Application number: **12844347.0**

(22) Date of filing: **19.10.2012**

(51) Int Cl.:
*H01L 31/04* (2014.01)

(86) International application number:
**PCT/JP2012/077095**

(87) International publication number:
**WO 2013/061881 (02.05.2013 Gazette 2013/18)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.10.2011 JP 2011234805**

(71) Applicant: **SUMITOMO CHEMICAL COMPANY LIMITED**
**Chuo-ku**
**Tokyo**
**104-8260 (JP)**

(72) Inventor: **FUKUURA, Tomohiro**
**Niihama-shi**
**Ehime 792-0015 (JP)**

(74) Representative: **Jackson, Martin Peter**
**J A Kemp**
**14 South Square**
**Gray's Inn**
**London WC1R 5JJ (GB)**

(54) **PHOTOELECTRIC CONVERSION ELEMENT**

(57) There is provided a photoelectric conversion device including: an active layer; and a metal-based particle assembly layer consisting of a particle assembly including 30 or more metal-based particles separated from each other and disposed in two dimensions, the metal-based particles having an average particle diameter in a range of from 10 to 1600 nm, an average height in a range of from 5 to 500 nm, and an aspect ratio in a range of from 0.5 to 8, the metal-based particles being disposed such that an average distance between adjacent metal-based particles may be in a range of from 1 to 150 nm. The photoelectric conversion device exhibits a high conversion efficiency achieved through enhancement of an electric field by the metal-based particle assembly layer.

FIG.1

EP 2 772 945 A1

## Description

TECHNICAL FIELD

The present invention relates to a photoelectric conversion device exploiting plasmon resonance of a metal-based particle assembly in aiming for improved conversion efficiency.

BACKGROUND ART

It has conventionally been known that making metal particles small to be nano-sized presents functions that are not observed when they are in a bulk state, and localized plasmon resonance is in particular expected for application. Plasmon is a compressional wave of free electrons that arises by collective oscillation of the free electrons in a metallic nanostructure.

In recent years, a field of art handling the plasmon is referred to as plasmonics and attracts large attention, and has also been actively studied. Such study includes exploiting phenomena of localized plasmon resonance of a metal nanoparticle to be intended for improvements of light emitting devices in luminescence efficiency or improvements of photoelectric conversion devices in conversion efficiency (photoelectric conversion efficiency).

Japanese Patent Laying-Open No. 2007-139540 (PTD 1), for example, discloses a technique exploiting phenomena of localized plasmon resonance for enhanced fluorescence of fluorescent materials. T. Fukuura and M. Kawasaki, "Long Range Enhancement of Molecular Fluorescence by Closely Packed Submicro-scale Ag Islands", e-Journal of Surface Science and Nanotechnology, 2009, 7, 653 (NPD 1) indicates a study on localized plasmon resonance of silver nanoparticles.

WO2006/085515 (PTD 2) discloses a light absorption enhancing element including a platinum-based metal-nanoparticle ultrathin film as a light absorption layer with its light absorptivity enhanced based on, for example, generation of an evanescent wave in the light absorption layer. Japanese Patent Laying-Open No. 2007-335222 (PTD 3) discloses a dye-sensitized solar cell having, on a transparent conductive thin-film of an electrode, a layered nanoparticle structure made up of regularly-arranged metal nanoparticles and semiconductor nanoparticles, and describes that interaction between the metal nanoparticles enhances localized surface plasmon resonance to thereby enable energy conversion efficiency to be improved.

CITATION LIST

PATENT DOCUMENT

PTD 1: Japanese Patent Laying-Open No. 2007-139540
PTD 2: WO2006/085515
PTD 3: Japanese Patent Laying-Open No. 2007-335222

NON PATENT DOCUMENT

NPD 1: T. Fukuura and M. Kawasaki, "Long Range Enhancement of Molecular Fluorescence by Closely Packed Submicro-scale Ag Islands", e-Journal of Surface Science and Nanotechnology, 2009, 7, 653

SUMMARY OF INVENTION

TECHNICAL PROBLEM

Photoelectric conversion devices, a typical example of which is the solar cell, exploiting localized plasmon resonance of conventional metal nanoparticles have not been recognized as producing an effect of sufficiently improving the conversion efficiency for the following reasons, and a photoelectric conversion device exhibiting a satisfactory conversion efficiency has not been achieved. Specifically, one of main factors of improvement in conversion efficiency of a photoelectric conversion device based on localized plasmon of metal nanoparticles is that generation of localized plasmon in a metal nanoparticle enhances an electric field near the metal nanoparticle and thereby enhance the exciton generation efficiency in an active layer. As for the conventional metal nanoparticles, however, the near electric field enhanced by plasmon is not relatively strong in terms of practical use. In addition, a range in which the electric-field enhancement effect is exerted (an effective range in which the plasmon-enhanced near electric field works) is smaller as compared with the thickness of many active layers which are commonly effective to work and thus the electric-field enhancement effect can only be available in a limited part of the active layer. Therefore, a sufficient electric-field enhancement effect has not been accomplished.

In view of the above, an object of the present invention is to provide a photoelectric conversion device that has an improved photoexcitation efficiency of its active layer, and can accordingly exhibit a high conversion efficiency through an enhancement of an electric field by a novel plasmonic material having a high electric-field enhancement capability.

SOLUTION TO PROBLEM

The present invention includes the following:

[1] A photoelectric conversion device comprising:

an active layer; and
a metal-based particle assembly layer consisting of a particle assembly including 30 or more metal-based particles separated from each other and disposed in two dimensions, the metal-based particles having an average particle diameter in a range of from 10 to 1600 nm, an average height in a range of from 5 to 500 nm, and an aspect ratio, as defined by a ratio of the average particle diameter to the average height, in a range of from 0.5 to 8, wherein
the metal-based particles that compose the metal-based particle assembly layer are disposed such that an average distance between adjacent metal-based particles (hereinafter also referred to as average interparticle distance) may be in a range of from 1 to 150 nm.

[2] A photoelectric conversion device comprising:

an active layer; and
a metal-based particle assembly layer consisting of a particle assembly including 30 or more metal-based particles separated from each other and disposed in two dimensions, the metal-based particles having an average particle diameter in a range of from 10 to 1600 nm, an average height in a range of from 5 to 500 nm, and an aspect ratio, as defined by a ratio of the average particle diameter to the average height, in a range of from 0.5 to 8, wherein
the metal-based particle assembly layer has in an absorption spectrum for a visible light region a maximum wavelength of a peak at a longest side in wavelength, and the maximum wavelength shifts toward a shorter side in wavelength in a range of from 30 to 500 nm as compared with that of a reference metal-based particle assembly (X) in which metal-based particles having a particle diameter equal to said average particle diameter and a height equal to said average height and made of the same material are disposed such that each distance between adjacent metal-based particles may be in a range of from 1 to 2 $\mu$m.

[3] A photoelectric conversion device comprising:

an active layer; and
a metal-based particle assembly layer consisting of a particle assembly including 30 or more metal-based particles separated from each other and disposed in two dimensions, the metal-based particles having an average particle diameter in a range of from 10 to 1600 nm, an average height in a range of from 5 to 500 nm, and an aspect ratio, as defined by a ratio of the average particle diameter to the average height, in a range of from 0.5 to 8, wherein
the metal-based particle assembly layer has in an absorption spectrum for a visible light region a maximum wavelength of a peak at a longest side in wavelength, and an absorbance at the maximum wavelength is higher as compared with that of a reference metal-based particle assembly (Y) in which metal-based particles having a particle diameter equal to said average particle diameter and a height equal to said average height and made of the same material are disposed such that each distance between adjacent metal-based particles may be in a range of from 1 to 2 $\mu$m, on the premise that the numbers of the metal-based particles are the same.

[4] The photoelectric conversion device according to any one of [1] to [3], comprising more than one said metal-based particle assembly layer.
[5] The photoelectric conversion device according to any one of [1] to [4], wherein the metal-based particles that compose the metal-based particle assembly layer are non-conductive between adjacent metal-based particles.
[6] The photoelectric conversion device according to any one of [1] to [5], wherein the metal-based particle assembly layer has in an absorption spectrum for a visible light region a maximum wavelength of a peak at a longest side in wavelength, and the maximum wavelength is in a range of from 350 to 550 nm.

[7] The photoelectric conversion device according to any one of [1] to [6], wherein the metal-based particle assembly layer has in an absorption spectrum for a visible light region a maximum wavelength of a peak at a longest side in wavelength, and an absorbance at the maximum wavelength is at least one.

[8] The photoelectric conversion device according to any one of [1] to [7], wherein the active layer has a thickness of 10 nm or more.

[9] The photoelectric conversion device according to any one of [1] to [8], wherein the photoelectric conversion device is an organic thin-film solar cell.

[10] A method of improving conversion efficiency of a photoelectric conversion device, the method comprising disposing in the photoelectric conversion device a metal-based particle assembly layer consisting of a particle assembly including 30 or more metal-based particles separated from each other and disposed in two dimensions, the metal-based particles having an average particle diameter in a range of from 10 to 1600 nm, an average height in a range of from 5 to 500 nm, and an aspect ratio, as defined by a ratio of the average particle diameter to the average height, in a range of from 0.5 to 8, wherein

the metal-based particles are disposed such that an average distance between adjacent metal-based particles may be in a range of from 1 to 150 nm.

[11] A method of improving conversion efficiency of a photoelectric conversion device, the method comprising disposing in the photoelectric conversion device a metal-based particle assembly layer consisting of a particle assembly including 30 or more metal-based particles separated from each other and disposed in two dimensions, the metal-based particles having an average particle diameter in a range of from 10 to 1600 nm, an average height in a range of from 5 to 500 nm, and an aspect ratio, as defined by a ratio of the average particle diameter to the average height, in a range of from 0.5 to 8, wherein

the metal-based particle assembly layer has in an absorption spectrum for a visible light region a maximum wavelength of a peak at a longest side in wavelength, and the maximum wavelength shifts toward a shorter side in wavelength in a range of from 30 to 500 nm as compared with that of a reference metal-based particle assembly in which metal-based particles having a particle diameter equal to said average particle diameter and a height equal to said average height and made of the same material are disposed such that each distance between adjacent metal-based particles may be in a range of from 1 to 2 $\mu$m

[12] A method of improving conversion efficiency of a photoelectric conversion device, the method comprising disposing in the photoelectric conversion device a metal-based particle assembly layer consisting of a particle assembly including 30 or more metal-based particles separated from each other and disposed in two dimensions, the metal-based particles having an average particle diameter in a range of from 10 to 1600 nm, an average height in a range of from 5 to 500 nm, and an aspect ratio, as defined by a ratio of the average particle diameter to the average height, in a range of from 0.5 to 8, wherein

the metal-based particle assembly layer has in an absorption spectrum for a visible light region a maximum wavelength of a peak at a longest side in wavelength, and an absorbance at the maximum wavelength is higher as compared with that of a reference metal-based particle assembly in which metal-based particles having a particle diameter equal to said average particle diameter and a height equal to said average height and made of the same material are disposed such that each distance between adjacent metal-based particles may be in a range of from 1 to 2 $\mu$m, on the premise that the numbers of the metal-based particles are the same.

## ADVANTAGEOUS EFFECTS OF INVENTION

The photoelectric conversion device of the present invention that includes a prescribed metal-based particle assembly layer having an excellent electric-field-enhancement capability can achieve a high conversion efficiency.

## BRIEF DESCRIPTION OF DRAWINGS

Fig. 1 is a schematic cross section view of an example photoelectric conversion device according to the present invention.

Fig. 2 is SEM images (as scaled 10000 times and 50000 times) of a metal-based particle assembly layer in a metal-based particle assembly layer-layered substrate obtained in Production Example 1, as observed from directly above.

Fig. 3 is an AFM image of the metal-based particle assembly layer in the metal-based particle assembly layer-layered substrate obtained in Production Example 1.

Fig. 4 is SEM images (as scaled 10000 times and 50000 times) of a metal-based particle assembly layer in a metal-based particle assembly layer-layered substrate obtained in Production Example 2, as observed from directly above.

Fig. 5 is an AFM image of the metal-based particle assembly layer in the metal-based particle assembly layer-layered substrate obtained in Production Example 2.

Fig. 6 is an SEM image (as scaled 10000 times) of a metal-based particle assembly layer in a metal-based particle assembly layer-layered substrate obtained in Comparative Production Example 1, as observed from directly above.

Fig. 7 is an AFM image of the metal-based particle assembly layer in the metal-based particle assembly layer-layered substrate obtained in Comparative Production Example 1.

Fig. 8 is an absorption spectrum of the metal-based particle assembly layer-layered substrate obtained in Production Example 1.

Fig. 9 is an absorption spectrum of the metal-based particle assembly layer-layered substrate obtained in Production Example 2.

Fig. 10 is schematic flow diagrams showing a method for producing a reference metal-based particle assembly.

Fig. 11 is SEM images (as scaled 20000 times and 50000 times) of a reference metal-based particle assembly layer in a reference metal-based particle assembly layer-layered substrate as observed from directly above.

Fig. 12 illustrates an absorption spectrum measurement method using an objective lens (100 times) of a microscope.

Fig. 13 is an absorption spectrum of the metal-based particle assembly layer-layered substrate obtained in Production Example 1, as measured by the method using an objective lens (100 times) of a microscope.

Fig. 14 is an absorption spectrum of the metal-based particle assembly layer-layered substrate obtained in Production Example 2, as measured by the method using an objective lens (100 times) of a microscope.

Fig. 15 is an absorption spectrum of the metal-based particle assembly layer-layered substrate obtained in Comparative Production Example 1, as measured by the method using an objective lens (100 times) of a microscope.

DESCRIPTION OF EMBODIMENTS

A photoelectric conversion device of the present invention is configured to include at least: an active layer (light absorption layer); and a metal-based particle assembly layer that is a layer (film) disposed in the photoelectric conversion device and consists of a particle assembly including 30 or more metal-based particles mutually separated and disposed in two dimensions.

In the present invention the metal-based particles that compose the metal-based particle assembly layer have an average particle diameter in a range of from 10 to 1600 nm, an average height in a range of from 5 to 500 nm, and an aspect ratio, as defined by a ratio of the average particle diameter to the average height, in a range of from 0.5 to 8.

<Metal-Based Particle Assembly Layer>

The photoelectric conversion device of the present invention in a preferred embodiment includes a metal-based particle assembly layer having any of the following features:

[i] the metal-based particles that compose the metal-based particle assembly layer are disposed such that an average distance between adjacent metal-based particles (average interparticle distance) may be in a range of from 1 to 150 nm (first embodiment);

[ii] the metal-based particle assembly layer has in an absorption spectrum for a visible light region a maximum wavelength of a peak at a longest side in wavelength, and the maximum wavelength shifts toward a shorter side in wavelength in a range of from 30 to 500 nm as compared with that of a reference metal-based particle assembly (X) in which metal-based particles having a particle diameter equal to the aforementioned average particle diameter and a height equal to the aforementioned average height and made of the same material are disposed such that each distance between adjacent metal-based particles may be in a range of from 1 to 2 $\mu$m (second embodiment); and

[iii] the metal-based particle assembly layer has in an absorption spectrum for a visible light region a maximum wavelength of a peak at a longest side in wavelength, and an absorbance at the maximum wavelength is higher as compared with that of a reference metal-based particle assembly (Y) in which metal-based particles having a particle diameter equal to the aforementioned average particle diameter and a height equal to the aforementioned average height and made of the same material are disposed such that each distance between adjacent metal-based particles may be in a range of from 1 to 2 $\mu$m, on the premise that the numbers of the metal-based particles are the same (third embodiment).

In the present specification, a metal-based particle assembly having an average particle diameter and an average height equal to those of the reference metal-based particle assembly (X) or (Y) herein means that the average particle diameters have a difference within a range of ±5 nm and the average heights have a difference within a range of ±10 nm.

(First Embodiment)

A photoelectric conversion device of the present embodiment including a metal-based particle assembly layer having the feature indicated above at item [i] is significantly advantageous as follows:

(1) The metal-based particle assembly layer according to the present embodiment exhibits relatively intense plasmon resonance and thus allows a stronger electric-field enhancement effect (an effect of enhancing an electric field near metal-based particles), than a conventional plasmonic material, even on a substance (light absorbent) forming an active layer separated by a certain distance from the surfaces of the metal-based particles. Accordingly, the photoexcitation efficiency of the active layer is increased and hence the conversion efficiency can drastically be increased. The plasmon-enhanced near electric field exhibited by the metal-based particle assembly layer according to the present embodiment can become to have an intensity that is not a simple sum total of a plasmon-enhanced near electric field derived from individual metal-based particles for a specific wavelength; rather, it exhibits an intensity larger than that. More specifically, 30 or more metal-based particles each having a prescribed shape are spaced as prescribed, as described above, to be closely disposed, thereby individually interacting with each other to exhibit a significantly intense plasmon-enhanced electric field. This is believed to be exhibited as the metal-based particles' localized plasmons interact with each other.

Generally, when a plasmonic material is subjected to absorption spectrum measurement through absorptiometry, a plasmon resonance peak (hereinafter also referred to as a plasmon peak) is observed as a peak in an ultraviolet to visible light region, and the plasmon peak's absorbance value in magnitude at a maximum wavelength thereof can be used to easily evaluate the plasmonic material's plasmon resonance in intensity, and when the metal-based particle assembly layer according to the present embodiment that is layered on a glass substrate is subjected to absorption spectrum measurement, it can present for a visible light region a maximum wavelength of a plasmon peak at a longest side in wavelength, and an absorbance at the maximum wavelength can be 1 or larger, further 1.5 or larger, and still further approximately 2.

The metal-based particle assembly layer's absorption spectrum is measured through absorptiometry with the layer layered on a glass substrate. More specifically, the absorption spectrum is obtained as follows: the glass substrate with the metal-based particle assembly layer layered thereon is exposed to light of the ultraviolet to visible light region incident on a back surface thereof (i.e., a side opposite to the metal-based particle assembly layer) in a direction perpendicular to a substrate surface and intensity $I$ of transmitted light omnidirectionally transmitted toward the metal-based particle assembly layer is measured with an integrating sphere spectrophotometer. On the other hand, a substrate which does not have a metal-based particle assembly film and has the same thickness and the same material as the substrate of said metal-based particle assembly film-layered substrate is exposed at a surface thereof to the same incident light as above in a direction perpendicular to that surface and intensity $I_0$ of transmitted light omnidirectionally transmitted through a side opposite to the incident surface is measured with the integrating sphere spectrophotometer. Then, the absorption spectrum's axis of ordinate, or absorbance, is expressed by the following expression:

$$\text{Absorbance} = -\log_{10}(I/I_0).$$

(2) The metal-based particle assembly layer presents a plasmon-enhanced electric field working in a significantly extended effective range and thus allows an electric-field enhancement effect to be achieved in a greater spatial region as compared with a case where a conventional plasmonic material is used, and this, as well as the above, contributes to drastically improved conversion efficiency. Namely, the significantly extended range in which the plasmon-enhanced electric field works allows the effect of enhancing the photoexcitation efficiency to work in a range of the common thickness of an active layer of a photoelectric conversion device. Thus, the conversion efficiency of the photoelectric conversion device can significantly be improved as compared with the conventional case where the electric-field enhancement effect works in a smaller range and only a part of the active layer can be enhanced. Such an effect of extending the effective range is also believed to be exhibited, as 30 or more metal-based particles each having a prescribed shape and spaced as prescribed to be closely disposed cause localized plasmons interacting with each other. The metal-based particle assembly layer according to the present embodiment allows the range in which the plasmon-enhanced electric field works to be extended for example to approximately several hundreds of nm. Therefore, the photoelectric conversion device of the present embodiment enables the plasmon's electric-field enhancement effect and the resultant effect of improving the conversion efficiency to be achieved even when the metal-based particle assembly layer is disposed at a position away from the active layer by, for example, 10 nm, or several tens of nm (more than 20 nm, 30 nm, or 40 nm for example), or even several hundreds of nm.

The metal-based particle assembly layer according to the present embodiment has at least a specific number of metal-based particles each having a prescribed shape and spaced as prescribed to be closely disposed, to thereby enable the intense plasmon resonance and significant extension of the effective range in which the plasmon-enhanced electric field work in the photoelectric conversion device.

Furthermore, as the photoelectric conversion device of the present embodiment has a metal-based particle assembly layer configured such that at least a specific number of metal-based particles having a specific shape are spaced in two dimensions, as prescribed, it can thereby have an advantageous effect, as follows.

(3) The metal-based particle assembly layer according to the present embodiment can present in an absorption spectrum for a visible light region a plasmon peak whose maximum wavelength presents a unique shift depending on its metal-based particles' average particle diameter and average interparticle distance. More specifically, when the metal-based particles having a prescribed aspect ratio have a fixed average interparticle distance on condition that interparticle interaction can be exhibited, while having increased average particle diameters, a plasmon peak at a longest side in wavelength for the visible light region has a maximum wavelength shifting toward a shorter side in wavelength (or blue-shifted). Similarly, when metal-based particles which are larger than a certain size have a fixed average particle diameter while having decreased average interparticle distances (i.e., when the particles are disposed more closely), a plasmon peak at a longest side in wavelength for the visible light region has a maximum wavelength shifting toward a shorter side in wavelength. This unique phenomenon is contradictory to the Mie-scattering theory generally accepted regarding plasmonic materials (according to this theory, larger particle diameters result in a plasmon peak having a maximum wavelength shifting toward a longer side in wavelength (or red-shifted)).

It is believed that the unique blue shift as described above is also attributed to the fact that the metal-based particle assembly layer is structured with metal-based particles each having a prescribed shape and spaced as prescribed to be closely disposed, followed by the metal-based particles having their localized plasmons interacting with each other. The metal-based particle assembly layer according to the present embodiment (when it is layered on a glass substrate) can present in an absorption spectrum for a visible light region, as measured through absorptiometry, a maximum wavelength of a plasmon peak at a longest side in wavelength, and the maximum wavelength can be in a wavelength range of for example from 350 to 550 nm, depending on the metal-based particles' shape and average interparticle distance. Furthermore, the metal-based particle assembly layer according to the present embodiment can typically cause a blue shift of approximately 30 to 500 nm (e.g., 30 to 250 nm) as compared with that having metal-based particles with a sufficiently large interparticle distance (for example of 1 $\mu$m).

The metal-based particle assembly layer with a plasmon peak having a maximum wavelength blue-shifted as described above, for example, a metal-based particle assembly layer having a plasmon peak in an ultraviolet- or near-ultraviolet-wavelength range or a short-wavelength range of visible light, is advantageous for improvement of the conversion efficiency of the photoelectric conversion device such as solar cell. In solar cells which are currently known widely, a part of solar light in the ultraviolet- or near-ultraviolet-wavelength range or a short wavelength range of visible light is hardly utilized depending on the configuration of the solar cell. In contrast, the above metal-based particle assembly layer can be included to thereby improve the efficiency of excitation by solar light in the above-described wavelength range, which can accordingly improve the conversion efficiency.

Hereinafter will be described a specific configuration of the metal-based particle assembly layer according to the present embodiment.

Metal-based particles that compose the metal-based particle assembly layer are not particularly restricted as long as made of a material having a plasmon peak in an ultraviolet to visible light region in absorption spectrum measurement through absorptiometry in the form of nanoparticles or an assembly of such particles, and the material can include, for example, noble metals such as gold, silver, copper, platinum and palladium; metals such as aluminum and tantalum; alloys containing these noble metals or these metals; and metal compounds containing these noble metals or these metals (such as metal oxides, and metal salts). Inter alia, noble metals such as gold, silver, copper, platinum, and palladium are preferable.

The metal-based particles have an average particle diameter within a range of from 10 to 1600 nm, and to effectively obtain the above-described effects of items (1) to (3) it falls within a range of preferably from 10 to 500 nm, more preferably from 10 to 250 nm. Preferably, the average particle diameter of the metal-based particles is selected as appropriate depending on for example the type of the metal-based material of which the metal-based particles are made.

The average particle diameter of the metal-based particles is obtained as follows: a metal-based particle assembly layer having metal-based particles disposed in two dimensions is observed with an SEM from directly above to obtain an SEM image thereof, and therein ten particles are selected at random and in each particle's image 5 tangential diametrical lines are drawn at random (note that the straight lines serving as the tangential diametrical lines can pass through only inside the image of the particle and one of the lines is a straight line passing through only inside the particle and drawable to be the longest) and their average value serves as the particle's diameter and the selected ten particles' respective such particle diameters are averaged to obtain the average particle diameter of the metal-based particles. The tangential diametrical line is defined as a perpendicular line connecting a spacing between two parallel lines sandwiching the particle's contour (in a projected image) in contact therewith (see Nikkan Kogyo Shimbun, Ltd., "Particle Measurement Technique", 1994, page 5).

The metal-based particles have an average height within a range of from 5 to 500 nm, and to effectively obtain the above-described effects of items (1) to (3) it falls within a range of preferably from 10 to 500 nm, more preferably from 10 to 250 nm. Preferably, the average height of the metal-based particles is selected as appropriate depending on for example the type of the metal-based material of which the metal-based particles are made. The average height of the metal-based particles is obtained as follows: the metal-based particle assembly layer (film) is observed with an AFM to obtain an AFM image thereof and therein ten particles are selected at random and measured in height and their measurements are averaged to obtain the average height.

The metal-based particles have an aspect ratio within a range of from 0.5 to 8 and to effectively obtain the above-described effects of items (1) to (3) it falls within a range of preferably from 1 to 5. In order to obtain a stronger electric-field enhancement effect, the aspect ratio is preferably smaller as long as interaction between localized plasmons of metal-based particles can be ensured sufficiently. It should be noted, however, in the case where the aspect ratio is small and the average particle diameter is too small, interaction between localized plasmons of metal-based particles may not be produced unless the particles are located extremely close to each other. The metal-based particle is preferably spherical. The aspect ratio of the metal-based particles is defined as a ratio of the above average particle diameter to the above average height (average particle diameter/average height).

While the metal-based particle preferably has a smoothly curved surface in view of exciting significantly effective plasmon, the metal-based particle may have a surface with small recesses and projections (roughness) to some extent and in that sense the metal-based particle may be indefinite in shape.

Preferably, the metal-based particles have variation therebetween in size as minimal as possible in view of uniformity in intensity of plasmon resonance within a plane of the metal-based particle assembly layer. Even if there is a small variation in particle diameter, it is not preferable that relatively-large-size particles have an increased distance therebetween and it is preferable that particles of smaller size be introduced between the relatively-large-size particles to help the relatively-large-size particles to exhibit their interaction.

The metal-based particle assembly layer according to the present embodiment has adjacent metal-based particles disposed to have an average distance therebetween (average interparticle distance) within a range of from 1 to 150 nm. Such closely disposed metal-based particles can realize intense plasmon resonance and a plasmon-enhanced electric field working in a significantly extended effective range, and furthermore, the above-described effect of item (3). The average interparticle distance is within a range of preferably from 1 to 100 nm, more preferably from 1 to 50 nm, still more preferably from 1 to 20 nm to effectively obtain the above-described effects of items (1) to (3). An average interparticle distance smaller than 1 nm results in occurrence of electron transfer between the particles attributed to the Dexter mechanism, which disadvantageously deactivates the resonance capability of plasmon of each particle in the metal-based particle assembly and the resonance capability of plasmon generated from the metal-based particle assembly (for example, causes the sharpness of the plasmon peak to be lost).

The average interparticle distance, as referred to herein, is obtained as follows: a metal-based particle assembly layer having metal-based particles disposed in two dimensions is observed with an SEM from directly above to obtain an SEM image thereof, and therein 30 particles are selected at random and for each selected particle an interparticle distance to an adjacent particle is obtained and the 30 particles' such interparticle distances are averaged to obtain an average interparticle distance. In obtaining an interparticle distance to an adjacent particle, a distance to any adjacent particle, as obtained between their surfaces, is measured, and such measurements are averaged to obtain the interparticle distance.

The metal-based particle assembly layer includes 30 or more metal-based particles, preferably 50 or more metal-based particles. 30 or more metal-based particles assembled together have their localized plasmons interacting with each other and thus exhibit intense plasmon resonance and a plasmon-enhanced electric field working in an extended effective range.

In light of a typical device area of the photoelectric conversion device, the metal-based particle assembly can include 300 or more metal-based particles, and furthermore, 17500 or more metal-based particles, for example.

The metal-based particle assembly layer includes metal-based particles having a number density preferably of 7 particles/$\mu$m$^2$ or larger, more preferably 15 particles/$\mu$m$^2$ or larger.

The metal-based particle assembly layer preferably has metal-based particles insulated from each other, that is, the layer is non-conductive between adjacent metal-based particles (the metal-based particle assembly layer in itself is non-conductive). If some or all of the metal-based particles can pass/receive electrons to/from each other, the plasmon peak loses sharpness and thus resembles an absorption spectrum of bulk metal, and high plasmon resonance is not obtained, either. Accordingly, it is preferable that the metal-based particles be surely separated and have no conductive substance interposed therebetween.

(Second Embodiment)

The present embodiment provides a photoelectric conversion device including a metal-based particle assembly layer (having the feature indicated above at item [ii]) showing in an absorption spectrum for a visible light region a maximum wavelength of a peak at a longest side in wavelength, and the maximum wavelength shifts toward a shorter side in wavelength in a range of from 30 to 500 nm as compared with that of the reference metal-based particle assembly (X). The photoelectric conversion device of the present embodiment including a metal-based particle assembly layer having such a feature is significantly advantageous as follows.

(I) The metal-based particle assembly layer according to the present embodiment shows in an absorption spectrum for the visible light region a maximum wavelength of a plasmon peak at a longest side in wavelength, and the maximum wavelength is present in a unique wavelength range. Specifically, when the metal-based particle assembly layer according to the present embodiment is subjected to absorption spectrum measurement, it presents the plasmon peak with a maximum wavelength shifted to a shorter side (or blue-shifted) in wavelength in a range of from 30 to 500 nm (e.g., 30 to 250 nm) as compared with a maximum wavelength of the reference metal-based particle assembly (X) described later, and typically the plasmon peak has the maximum wavelength within a range of from 350 to 500 nm.

It is believed that the blue shift as described above is attributed to the fact that the metal-based particle assembly layer is structured with at least a specific number of metal-based particles each having a prescribed shape and separated in two dimensions, followed by the metal-based particles having their localized plasmons interacting with each other.
The metal-based particle assembly layer with a plasmon peak having a maximum wavelength blue-shifted as described above, for example, a metal-based particle assembly layer having a plasmon peak in an ultraviolet- or near-ultraviolet-wavelength range or a short-wavelength range of visible light, is advantageous in that it has possibility to improve the conversion efficiency of the photoelectric conversion device, since the efficiency of excitation by solar light in the above-described wavelength range which is hardly utilized in the conventionally known solar cells has possibility to be improved.
When a metal-based particle assembly and a reference metal-based particle assembly (X) are observed to compare the maximum wavelengths of their peaks at a longest side in wavelength and the absorbances at the maximum wavelengths, a microscope ("OPTIPHOT-88" produced by Nikon) and a spectrophotometer ("MCPD-3000" produced by Otsuka Electronics Co., Ltd.) are used to perform absorption spectrum measurement in a narrowed field of view.
The reference metal-based particle assembly (X) is a metal-based particle assembly in which metal-based particles A that have a particle diameter and a height equal to the average particle diameter and the average height of a metal-based particle assembly layer subject to absorption spectrum measurement and are identical in material to the metal-based particles of the metal-based particle assembly layer are disposed such that each distance between adjacent metal-based particles may be in a range of from 1 to 2 $\mu$m, and the reference metal-based particle assembly (X) has a size allowing the reference metal-based particle assembly (X) layered on a glass substrate to undergo absorption spectrum measurement via a microscope, as described above.
The wave pattern of the reference metal-based particle assembly (X)'s absorption spectrum is also theoretically calculatable in the 3D-FDTD method using the particle diameter and height of metal-based particle A, the dielectric function of a material of metal-based particle A, the dielectric function of a medium (e.g., air) surrounding metal-based particle A, and the dielectric function of the substrate (e.g., a glass substrate).
Furthermore, as the photoelectric conversion device of the present embodiment has a metal-based particle assembly layer structured with at least a specific number of metal-based particles each having a prescribed shape and separated in two dimensions, (II) the metal-based particle assembly layer can exhibit relatively intense plasmon resonance and thus allows a stronger electric-field enhancement effect than a conventional plasmonic material, and hence drastically increased conversion efficiency, which is similar to effect (1) of the first embodiment, and (III) the metal-based particle assembly layer can present a plasmon-enhanced electric field working in a significantly extended effective range (a range in which the plasmon's electric-field enhancement effect is exerted) and thus allows a higher light-excitation-efficiency enhancement effect than a conventional plasmonic material, and can similarly increase the conversion efficiency, which is similar to effect (2) of the first embodiment. When the metal-based particle assembly layer according to the present embodiment that is layered on a glass substrate is subjected to absorption spectrum measurement, it can present for the visible light region a maximum wavelength of a plasmon peak at a longest side in wavelength, and an absorbance at the maximum wavelength can be 1 or larger, further 1.5 or larger, and still further approximately 2.
Hereinafter will be described a specific configuration of the metal-based particle assembly layer according to the present embodiment. The metal-based particle assembly layer according to the present embodiment can have a specific configuration (for the material, average particle diameter, average height, aspect ratio, average interparticle distance, and count of the metal-based particles, the metal-based particle assembly layer's non-conductance, and the like) basically similar to that of the metal-based particle assembly layer according to the first embodiment. The terms including average particle diameter, average height, aspect ratio, and average interparticle distance are defined as in the first embodiment.

The metal-based particles have an average particle diameter within a range of from 10 to 1600 nm, and to effectively obtain the above-described effects of items (1) to (III) it falls within a range of preferably from 10 to 500 nm, more preferably from 10 to 250 nm. Preferably, the average particle diameter of the metal-based particles is selected as appropriate depending on for example the type of the metal-based material of which the metal-based particles are made.

The metal-based particle assembly layer according to the present embodiment shows for a visible light region a maximum wavelength of a plasmon peak at a longest side in wavelength, and the maximum wavelength depends on the metal-based particles' average particle diameter. More specifically, when the metal-based particles have an average particle diameter exceeding a certain value, the plasmon peak has the maximum wavelength shifting toward a shorter side in wavelength (or blue-shifted).

The metal-based particles have an average height within a range of from 5 to 500 nm, and to effectively obtain the above-described effects of items (I) to (III) it falls within a range of preferably from 10 to 500 nm, more preferably from 10 to 250 nm. Preferably, the average height of the metal-based particles is selected as appropriate depending on for example the type of the metal-based material of which the metal-based particles are made.

The metal-based particles have an aspect ratio within a range of from 0.5 to 8 and to effectively obtain the above-described effects of items (I) to (III) it falls within a range of preferably from 1 to 5. In order to obtain a stronger electric-field enhancement effect, the aspect ratio is preferably smaller as long as interaction between localized plasmons of metal-based particles can be ensured sufficiently. It should be noted, however, in the case where the aspect ratio is small and the average particle diameter is too small, interaction between localized plasmons of metal-based particles may not be produced unless the particles are located extremely close to each other. The metal-based particle is preferably spherical.

While the metal-based particle preferably has a smoothly curved surface in view of exciting significantly effective plasmon, the metal-based particle may have a surface with small recesses and projections (or roughness) to some extent and in that sense the metal-based particle may be indefinite in shape. Preferably, the metal-based particles have variation therebetween in size as minimal as possible in view of uniformity in intensity of plasmon resonance within a plane of the metal-based particle assembly layer. Note, however, that, as has been set forth above, even if there is a small variation in particle diameter, it is not preferable that relatively-large-size particles have an increased distance therebetween, but it is preferable that particles of smaller size be introduced between the relatively-large-size particles to help the relatively-large-size particles to exhibit their interaction.

Preferably, the metal-based particle assembly layer according to the present embodiment has metal-based particles disposed to have an average interparticle distance within a range of from 1 to 150 nm. More preferably, it is within a range of from 1 to 100 nm, still more preferably from 1 to 50 nm, particularly more preferably from 1 to 20 nm. Such closely disposed metal-based particles present the metal-based particles' localized plasmons interacting with each other effectively and thus facilitate presenting the above-described effects of items (I) to (III). As a maximum wavelength of the plasmon peak depends on the metal-based particles' average interparticle distance, the average interparticle distance can be adjusted to control to what extent a plasmon peak at a longest side in wavelength should be blue-shifted, and the plasmon peak's maximum wavelength. An average interparticle distance smaller than 1 nm results in occurrence of electron transfer between the particles attributed to the Dexter mechanism, which disadvantageously deactivates the resonance capability of plasmon of each particle in the metal-based particle assembly and the resonance capability of plasmon generated from the metal-based particle assembly (for example, causes the sharpness of the plasmon peak to be lost).

Another means other than the above means to present the above-described feature of item [ii] (a plasmon peak shifted to a shorter side in wavelength) can for example be introducing between the metal-based particles a dielectric substance having a dielectric constant different from that of air, which is preferably a non-conductive substance, as will be described later.

The metal-based particle assembly layer includes 30 or more metal-based particles, preferably 50 or more metal-based particles. 30 or more metal-based particles assembled together present the metal-based particles' localized plasmons interacting with each other effectively and thus allow the feature of item [ii] and the effects of items (I) to (III) to be presented.

In light of a typical device area of the photoelectric conversion device, the metal-based particle assembly can include 300 or more metal-based particles, and furthermore, 17500 or more metal-based particles, for example.

The metal-based particle assembly layer includes metal-based particles having a number density preferably of 7 particles/$\mu$m$^2$ or larger, more preferably 15 particles/$\mu$m$^2$ or larger.

The metal-based particle assembly layer of the present embodiment, as well as that of the first embodiment, preferably has metal-based particles insulated from each other, that is, the layer is non-conductive between adjacent metal-based particles (the metal-based particle assembly layer in itself is non-conductive).

(Third Embodiment)

The present embodiment provides a photoelectric conversion device including a metal-based particle assembly layer (having the feature of item [iii] above) showing in an absorption spectrum for a visible light region a maximum wavelength of a peak at a longest side in wavelength, and an absorbance at the maximum wavelength is higher as compared with that of the reference metal-based particle assembly (Y), on the premise that the numbers of metal-based particles are the same. The photoelectric conversion device of the present embodiment including a metal-based particle assembly layer having such a feature is significantly advantageous in the following points.

(A) The metal-based particle assembly layer according to the present embodiment shows for a visible light region a maximum wavelength of a peak at a longest side in wavelength, or a plasmon peak, and an absorbance at the maximum wavelength is higher as compared with that of the reference metal-based particle assembly (Y) that can be regarded as an assembly of metal-based particles simply assembled together without any interparticle interaction. Accordingly, the metal-based particle assembly layer exhibits more intense plasmon resonance, and thus allows a stronger electric-field enhancement effect than a conventional plasmonic material, and hence drastically increased conversion efficiency. It is believed that such intense plasmon resonance is exhibited as the metal-based particles present localized plasmons interacting with each other.

As has been described above, the plasmon peak's absorbance value in magnitude at the maximum wavelength thereof can be used to easily evaluate the plasmonic material's plasmon resonance in intensity, and when the metal-based particle assembly layer according to the present embodiment that is layered on a glass substrate is subjected to absorption spectrum measurement, it can present for a visible light region a maximum wavelength of a plasmon peak at a longest side in wavelength, and an absorbance at the maximum wavelength can be 1 or larger, further 1.5 or larger, and still further approximately 2.

As has been described above, when a metal-based particle assembly and a reference metal-based particle assembly (Y) are observed to compare the maximum wavelengths of their peaks at a longest side in wavelength and the absorbances at the maximum wavelengths, a microscope ("OPTIPHOT-88" produced by Nikon) and a spectrophotometer ("MCPD-3000" produced by Otsuka Electronics Co., Ltd.) are used to perform absorption spectrum measurement in a narrowed field of view.

The reference metal-based particle assembly (Y) is a metal-based particle assembly in which metal-based particles B that have a particle diameter and a height equal to the average particle diameter and average height of a metal-based particle assembly layer subject to absorption spectrum measurement and are identical in material to the metal-based particles of the metal-based particle assembly layer are disposed such that each distance between adjacent metal-based particles may be in a range of from 1 to 2 $\mu$m, and the reference metal-based particle assembly (Y) has a size allowing the reference metal-based particle assembly (Y) layered on a glass substrate to undergo absorption spectrum measurement via a microscope, as described above.

When the metal-based particle assembly layer subject to absorption spectrum measurement and the reference metal-based particle assembly (Y) are compared in their absorbances at the maximum wavelengths of their peaks at a longest side in wavelength, an absorption spectrum of the reference metal-based particle assembly (Y) as converted to have the same number of metal-based particles is obtained and an absorbance at a maximum wavelength of a peak in that absorption spectrum, which peak is present at a longest side in wavelength, is used as a target for comparison, as will be described hereinafter. Specifically, an absorption spectrum of the metal-based particle assembly and that of the reference metal-based particle assembly (Y) are obtained and the absorbances at the maximum wavelengths of the peaks in the absorption spectra, which peaks are present at a longest side in wavelength, respectively, are divided by their respective coverages (the coverages of their respective substrates' surfaces by the metal-based particles), and the obtained values are compared.

Furthermore, as the photoelectric conversion device of the present embodiment has a metal-based particle assembly layer structured with at least a specific number of metal-based particles each having a prescribed shape and separated in two dimensions, it can have such effects as follows: (B) the metal-based particle assembly layer can present a plasmon-enhanced electric field working in a significantly extended effective range (a range in which the plasmon's electric-field enhancement effect is exerted) and thus allows a higher light-excitation-efficiency enhancement effect than a conventional plasmonic material, and hence drastically increased conversion efficiency, which is similar to effect (2) of the first embodiment; and (C) the metal-based particle assembly layer can exhibit a plasmon peak having a maximum wavelength uniquely shifted and thus allows the efficiency of excitation by solar light in the above-described wavelength range to be improved and accordingly allows the conversion efficiency to be improved, which is similar to effect (3) of the first embodiment; and the like.

The metal-based particle assembly layer of the present embodiment (when it is layered on a glass substrate) can present in an absorption spectrum for a visible light region, as measured through absorptiometry, a maximum wavelength of a plasmon peak at a longest side in wavelength, and the maximum wavelength can be in a range of for example from 350 to 550 nm, depending on the metal-based particles' shape and interparticle distance. Furthermore, the metal-based particle assembly layer of the present embodiment can typically cause a blue shift of approximately 30 to 500 nm (30 to 250 nm for example) as compared with that having metal-based particles with a sufficiently large interparticle distance (for example of 1 μm).

Hereinafter will be described a specific configuration of the metal-based particle assembly layer according to the present embodiment. The metal-based particle assembly layer according to the present embodiment can have a specific configuration (for the material, average particle diameter, average height, aspect ratio, average interparticle distance, and count of the metal-based particles, the metal-based particle assembly layer's non-conductance, and the like) basically similar to that of the metal-based particle assembly layer according to the first embodiment. The terms including average particle diameter, average height, aspect ratio, and average interparticle distance are defined as in the first embodiment.

The metal-based particles have an average particle diameter within a range of from 10 to 1600 nm, and to effectively obtain the above-described feature of item [iii] (i.e., to have an absorbance at a maximum wavelength of a plasmon peak at a longest side in wavelength, which absorbance is larger than that of the reference metal-based particle assembly (Y)), and furthermore the above-described effects of items (A) to (C), it falls within a range of preferably from 10 to 500 nm, more preferably from 10 to 250 nm. Preferably, the average particle diameter of the metal-based particles is selected as appropriate depending on for example the type of the metal-based material of which the metal-based particles are made.

The metal-based particles have an average height within a range of from 5 to 500 nm, and to effectively obtain the above-described feature of item [iii] and furthermore, the above-described effects of items (A) to (C), it falls within a range of preferably from 10 to 500 nm, more preferably from 10 to 250 nm. Preferably, the average height of the metal-based particles is selected as appropriate depending on for example the type of the metal-based material of which the metal-based particles are made.

The metal-based particles have an aspect ratio within a range of from 0.5 to 8, and to effectively obtain the above-described feature of item [iii] and furthermore, the above-described effects of items (A) to (C), it falls within a range of preferably from 1 to 5. In order to obtain a stronger electric-field enhancement effect, the aspect ratio is preferably smaller as long as interaction between localized plasmons of metal-based particles can be ensured sufficiently. It should be noted, however, in the case where the aspect ratio is small and the average particle diameter is too small, interaction between localized plasmons of metal-based particles may not be produced unless the particles are located extremely close to each other. The metal-based particle is preferably spherical.

While the metal-based particle preferably has a smoothly curved surface in view of exciting significantly effective plasmon, the metal-based particle may have a surface with small recesses and projections (or roughness) to some extent and in that sense the metal-based particle may be indefinite in shape.

Preferably, the metal-based particle assembly layer is configured of as uniform metal-based particles as possible in shape (average particle diameter, average height, and aspect ratio), as such metal-based particles can effectively achieve the above-described feature of item [iii]. More specifically, uniforming the metal-based particles in shape provides a sharp plasmon peak, followed by that an absorbance of a plasmon peak at a longest side in wavelength facilitates being higher than that of the reference metal-based particle assembly (Y). Metal-based particles less varying in shape are also advantageous in view of uniformity in intensity of plasmon resonance within a plane of the metal-based particle assembly layer. Note, however, that, as has been set forth above, even if there is a small variation in particle diameter, it is not preferable that relatively large-size particles have an increased distance therebetween, but it is preferable that particles of smaller size be introduced between the relatively large-size particles to help the relatively large-size particles to exhibit their interaction.

Preferably, the metal-based particle assembly layer according to the present embodiment has metal-based particles disposed to have an average interparticle distance within a range of from 1 to 150 nm. More preferably, it is within a range of from 1 to 100 nm, still more preferably from 1 to 50 nm, particularly more preferably from 1 to 20 nm. Such closely disposed metal-based particles present the metal-based particles' localized plasmons interacting with each other effectively and thus allow the above-described feature of item [iii] and furthermore, the above-described effects of items (A) to (C) to be effectively presented. An average interparticle distance smaller than 1 nm results in occurrence of electron transfer between the particles attributed to the Dexter mechanism, which disadvantageously deactivates the resonance capability of plasmon of each particle in the metal-based particle assembly and the resonance capability of plasmon generated from the metal-based particle assembly (for example, causes the sharpness of the plasmon peak to be lost).

The metal-based particle assembly layer includes 30 or more metal-based particles, preferably 50 or more metal-based particles. 30 or more metal-based particles assembled together present the metal-based particles' localized plasmons interacting with each other effectively and thus allow the above-described feature of item [iii] and furthermore, the above-described effects of items (A) to (C) to be effectively presented.

In light of a typical device area of the photoelectric conversion device, the metal-based particle assembly can include 300 or more metal-based particles, and furthermore, 17500 or more metal-based particles, for example.

The metal-based particle assembly layer includes metal-based particles having a number density preferably of 7 particles/$\mu$m$^2$ or larger, more preferably 15 particles/$\mu$m$^2$ or larger.

The metal-based particle assembly layer of the present embodiment, as well as that of the first embodiment, preferably has metal-based particles insulated from each other, that is, the layer is non-conductive between adjacent metal-based particles (the metal-based particle assembly layer in itself is non-conductive).

Thus the metal-based particle assembly layer of the present embodiment having the above-described feature of item [iii] can be obtained by controlling its constituent metal-based particles in metal type, shape, average interparticle distance, and the like.

The metal-based particle assembly layer that the photoelectric conversion device of the present invention includes preferably has the feature of any one of items [i] to [iii], more preferably any two or more thereof, and still more preferably all thereof.

<Method for Producing Metal-Based Particle Assembly Layer>

A metal-based particle assembly layer according to the present invention including the metal-based particle assembly layers according to the first to third embodiments can be produced in such a method as follows:

(1) a bottom-up method to grow metal-based particles from minute seeds on a substrate;
(2) a method in which a metal-based particle that has a prescribed shape is covered with a protection layer made of an amphiphilic material and having a prescribed thickness, and the resultant is then subjected to langmuir blodgett (LB) deposition to be formed in a film on a substrate; and
(3) other methods, such as a method of post-treating a thin film obtained by vapor deposition, sputtering or the like; resist-processing; etching processing; a casting method using a liquid having metal-based particles dispersed therein, and the like.

It is important that method (1) includes the step of growing metal-based particles at a significantly low speed on a substrate adjusted to have a prescribed temperature (hereinafter also referred to as the particle growth step). A production method including the particle growth step can provide a satisfactorily controlled layer (thin film) of a metal-based particle assembly having 30 or more metal-based particles mutually separated and disposed in two dimensions, and having a shape within a prescribed range (an average particle diameter of 10 to 1600 nm, an average height of 5 to 500 nm, and an aspect ratio of 0.5 to 8) and still preferably an average interparticle distance within a prescribed range (1 to 150 nm).

In the particle growth step, the metal-based particles are grown on the substrate preferably at an average height growth rate smaller than 1 nm/minute, more preferably 0.5 nm/minute or smaller. The average height growth rate as referred to herein can also be referred to as an average deposition rate or the metal-based particle's average thickness growth rate, and is defined by the following expression:

$$\text{metal-based particles' average height / metal-based particle growth time}$$
$$\text{(supplying time of a metal-based material)}.$$

The "metal-based particles' average height" is defined as set forth above.

In the particle growth step, the substrate is set in temperature within a range of preferably from 100 to 450°C, more preferably from 200 to 450°C, still more preferably from 200 to 350°C, and particularly still more preferably from 250 to 350°C.

When the production method includes the particle growth step to grow metal-based particles at an average height growth rate smaller than 1 nm/minute on a substrate adjusted in temperature within the range of from 100 to 450°C, the particles are initially grown such that a supplied metal-based material forms a plurality of island structures, and as the metal-based material is further supplied the island structures are further grown and thus merged with neighboring island structures, and consequently, metal-based particles are closely disposed while metal-based particles each are completely separated from each other to form a metal-based particle assembly layer. Thus, a metal-based particle assembly layer can be produced that is formed of metal-based particles controlled to have a shape within a prescribed range (in average particle diameter, average height, and aspect ratio) and still preferably an average interparticle distance within a prescribed range.

Furthermore, the average height growth rate, the substrate's temperature and/or the metal-based particle growth time (the supplying time of the metal-based material) can be adjusted to also control within a prescribed range the average particle diameter, the average height, the aspect ratio, and/or the average interparticle distance of the metal-based particles grown on the substrate.

Furthermore, the production method including the particle growth step also allows the particle growth step to be performed such that conditions other than the substrate's temperature and the average height growth rate are selected relatively freely, and the method thus also advantageously allows a metal-based particle assembly layer of a desired size to be efficiently formed on a substrate of a desired size.

If the average height growth rate is 1 nm/minute or larger, or the substrate has a temperature lower than 100°C or higher than 450°C, then before the island structure is grown to be large the island structure forms a continuum with a neighboring island structure and a metal-based assembly formed of metal-based particles mutually completely separated cannot be obtained or a metal-based assembly formed of metal-based particles having a desired shape cannot be obtained (for example, it would depart in average height, average interparticle distance, and aspect ratio from a desired range).

While the metal-based particles are grown under a pressure (in an apparatus's chamber), which is not particularly restricted but may be any pressure that allows the particles to be grown, it is normally lower than atmospheric pressure. While the pressure's lower limit is not limited to a specific value, it is preferably 6 Pa or larger, more preferably 10 Pa or larger, still more preferably 30 Pa or larger, as such pressure helps to adjust the average height growth rate within the range indicated above.

The metal-based particles can specifically be grown on a substrate in any method allowing the particles to be grown at an average height growth rate smaller than 1 nm/minute, and the method can include sputtering, and vapor deposition such as vacuum deposition. Preferable sputtering is direct current (DC) sputtering as it allows a metal-based particle assembly layer to be grown relatively conveniently and also facilitates maintaining the average height growth rate smaller than 1 nm/minute. The sputtering may be done in any system and it can for example be an ion gun, or be direct current argon ion sputtering to expose a target to argon ions generated by a plasma discharge and accelerated in an electric field. The sputtering is done with a current value, a voltage value, a substrate-to-target distance and other conditions adjusted as appropriate to grow particles at an average height growth rate smaller than 1 nm/minute.

Note that to obtain a satisfactorily controlled metal-based particle assembly layer formed of metal-based particles having a shape within a prescribed range (in average particle diameter, average height, and aspect ratio) and still preferably an average interparticle distance within a prescribed range, it is preferable that the particle growth step be performed at an average height growth rate smaller than 1 nm/minute and in addition thereto an average particle diameter growth rate smaller than 5 nm, and when the average height growth rate is smaller than 1 nm/minute, the average particle diameter growth rate is normally smaller than 5 nm. The average particle diameter growth rate is more preferably 1 nm/minute or smaller. The average particle diameter growth rate is defined by the following expression:

$$\text{metal-based particles' average particle diameter / metal-based particle growth time (supplying time of a metal-based material)}.$$

The "metal-based particles' average particle diameter" is defined as set forth above.

The metal-based particle growth time (the supplying time of a metal-based material) in the particle growth step is a period of time that at least allows metal-based particles carried on a substrate to attain a shape within a prescribed range and still preferably an average interparticle distance within a prescribed range and that is smaller than a period of time allowing the particles to depart from the shape within the prescribed range and the average interparticle distance within the prescribed range. For example, even if particle growth is performed at an average height growth rate and a substrate temperature within the above prescribed ranges, an extremely long time taken for growth may result in a metal-based material carried in an excessively large amount and accordingly it will not form an assembly of mutually separated metal-based particles and instead form a continuous film or be metal-based particles excessively large in average particle size or average height.

Accordingly it is necessary to grow metal-based particles in an appropriately set period of time (to stop the particle growth step at an appropriate time), and such time can be set based for example on a relationship between an average height growth rate and a substrate's temperature and a shape and an average interparticle distance of metal-based particles of a resultant metal-based particle assembly, as obtained in advance through an experiment. Alternatively a time elapsing before a thin film of a metal-based material grown on a substrate exhibits conduction, that is, a time allowing the thin film to be a continuous film rather than a metal-based particle assembly film, may be obtained in advance through an experiment and the particle growth step may be stopped before that time is reached.

The metal-based particles are grown on a substrate preferably having as smooth a surface as possible and, inter alia, more preferably a surface that is smooth at the atomic level. When the substrate has a smoother surface, thermal energy received from the substrate helps a growing metal-based particle to merge with a surrounding, adjacent metal-based particle and thus grow, and thus there is a tendency to facilitate providing a film formed of metal-based particles of a larger size.

The substrate on which the metal-based particles are grown can be used as it is as a substrate of the photoelectric conversion device. That is, a substrate having a metal-based particle assembly layer layered or carried thereon, as produced in the above method (a metal-based particle assembly layer-layered substrate) can be used as a constituent member of the photoelectric conversion device.

<Configuration of Photoelectric Conversion Device>

The photoelectric conversion device of the present invention includes at least an active layer (light absorption layer) and the above-described metal-based particle assembly layer. The photoelectric conversion device of the present invention can include this metal-based particle assembly layer to thereby have an improved photoexcitation efficiency and accordingly exhibit a high conversion efficiency. The photoelectric conversion device of the present invention may be configured similarly to the conventionally known photoelectric conversion device except that the photoelectric conversion device of the present invention includes the above-described metal-based particle assembly layer within the device.

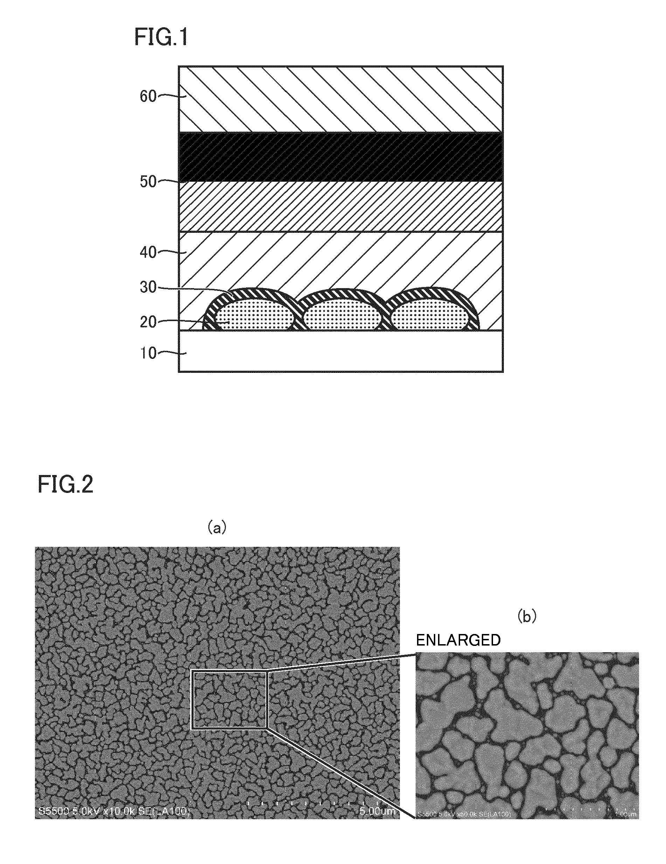

Fig. 1 is a schematic cross section view of an example photoelectric conversion device of the present invention, and shows an example structure of an organic thin-film solar cell given as an example of the photoelectric conversion device. The organic thin-film solar cell shown in Fig. 1 includes: a pair of electrode layers that are a first electrode layer 40 and a second electrode layer 60; an active layer (light absorption layer) 50 made of an organic material and disposed between first electrode layer 40 and second electrode layer 60; and a metal-based particle assembly layer that is a layer (film) consisting of a particle assembly disposed in the organic thin-film solar cell and including 30 or more metal-based particles 20 mutually separated and disposed in two dimensions. As shown in Fig. 1, the organic thin-film solar cell (as well as other photoelectric conversion devices) may be configured to include the above-described constituent layers layered on a substrate 10, like the common photoelectric conversion device.

The metal-based particle assembly layer is not limited to the example in Fig. 1 where the metal-based particle assembly layer is layered on the active-layer-50-side surface of substrate 10, but may be located at any position within the photoelectric conversion device. For example, the metal-based particle assembly layer may be disposed on the active-layer-50-side surface of first electrode layer 40, the active-layer-50-side surface of second electrode layer 60, the outer surface of second electrode layer 60, or the like. As described above, the present invention can significantly extend the effective range in which a plasmon-enhanced electric field given by the metal-based particle assembly layer works. Therefore, even when the metal-based particle assembly layer is disposed at a position away from active layer 50, a satisfactory electric-field enhancement effect and a resultant conversion-efficiency improvement effect can be achieved.

In the organic thin-film solar cell shown in Fig. 1, the metal-based particle assembly layer is layered (carried) directly on substrate 10. The metal-based particle assembly layer and substrate 10 thus stacked in layers can preferably be applied to the metal-based particle assembly layer-layered substrate that can be produced by the above-described method.

While substrate 10 may be made of any material which includes materials conventionally used for a substrate of a photoelectric conversion device such as solar cell as long as the substrate is light-transmittable (preferably optically transparent), it is preferable that the substrate be a non-conductive substrate to ensure that the metal-based particle assembly layer is non-conductive especially when the metal-based particle assembly layer is layered directly on substrate 10. For the non-conductive substrate, any of glass, a variety of other inorganic insulating materials ($SiO_2$, $ZrO_2$, mica, and the like), and a variety of plastic materials, may be used.

As shown in Fig. 1, the organic thin-film solar cell of the present invention (as well as other photoelectric conversion devices) may further include an insulating layer 30 covering a surface of each of metal-based particles 20 constituting the metal-based particle assembly layer. Such insulating layer 30 can ensure that the metal-based particle assembly layer is non-conductive (the metal-based particles are non-conductive therebetween) as described above, and insulating layer 30 also allows the metal-based particle assembly layer and an adjacent layer to be electrically insulated from each other. While the photoelectric conversion device has each constituent layer with current passing therethrough, the metal-based particle assembly layer with current passing therethrough may result in failure to obtain a sufficient electric-field enhancement effect via plasmon resonance. Providing insulating layer 30 that caps the metal-based particle assembly layer allows the metal-based particle assembly layer and its adjacent layer to be electrically insulated from each other and can thus prevent current from being injected into the metal-based particles forming the metal-based particle assembly.

It should be noted, however, in the case where the metal-based particle assembly layer is applied to a photoelectric conversion device which is configured so that a process of converting excited plasmon (electron oscillation) into electron transition works, the insulating layer inhibits the electron transition. Therefore, it is not preferable to electrically insulate the metal-based particles by the insulating layer.

Insulating layer 30 is formed of any material that is not particularly restricted as long as having satisfactory insulation, and it can be formed for example of spin on glass (SOG; containing organic siloxane material for example), or alternatively, $SiO_2$, $Si_3N_4$ or the like. While insulating layer 30 is of any thickness that is not particularly restricted as long as ensuring desired insulation, it is better that insulating layer 30 is smaller in thickness in a range ensuring desired insulation, as it is preferable that active layer 50 and the metal-based particle assembly layer be closer in distance, as will be described later.

Active layer 50, first electrode layer 40, and second electrode layer 60 in the organic thin-film solar cell shown in Fig. 1 can be configured of materials conventionally known in the field of the art and may also have respective thicknesses that a photoelectric conversion device normally has. Active layer 50 can for example be an active layer of the bulk hetero-junction type. Examples of such an active layer may include a mixed film made up of a p-type conductive polymer (polythiophene such as P3HT for example) and a fullerene derivative (PCMB for example) serving as n-type semiconductor. First electrode layer 40 can be a transparent electrode made for example of indium tin oxide (ITO), indium zinc oxide (IZO), or the like. Second electrode layer 60 can be a metal electrode made for example of Al, Ag, or the like. The photoelectric conversion device of the present invention can include, depending on its configuration, other layers that the conventional photoelectric conversion device may include, such as an electron transport layer, a hole transport layer, or the like if the photoelectric conversion device is an organic thin-film solar cell for example.

The photoelectric conversion device of the present invention is not restricted to the above-described organic thin-film solar cell, and can be silicon-based solar cell, compound-based solar cell, dye-sensitized solar cell, quantum dot solar cell, or the like. In particular, the photoelectric conversion device of the present invention is preferably an organic thin-film solar cell that is advantageous in terms of production cost while its conversion efficiency is currently low which has created a strong demand for improvement in conversion efficiency.

The active layer in the photoelectric conversion device may have a thickness for example of 10 nm or more, or 20 nm or more, or a still larger thickness (on the order of 100 nm for example). The present invention includes the metal-based particle assembly layer exhibiting a strong effect of enhancing an electric field by means of plasmon as well as a significantly extended effective range in which the plasmon-enhanced electric field works (a range in which the plasmon's electric-field enhancement effect is exerted). Therefore, even when the active layer has a large thickness, the photoexcitation efficiency can be improved across the whole active layer, which can thereby significantly improve the conversion efficiency.

In the photoelectric conversion device of the present invention, the distance between the active layer and the metal-based particle assembly layer (the distance from the active-layer-side-surface of the metal-based particle assembly layer to the active layer) is not particularly restricted. Even when the metal-based particle assembly layer is disposed at a position away from the active layer by, for example, 10 nm, or several tens of nm (more than 20 nm, 30 nm, or 40 nm for example), or even several hundreds of nm as described above, the electric-field enhancement effect derived from the plasmon-enhanced electric field and the resultant effects of improving the photoexcitation efficiency and the conversion efficiency can still be achieved.

In a preferred embodiment of the present invention, a plurality of metal-based assembly layers are provided in the photoelectric conversion device, and particularly, a plurality of (two or more) metal-based particle assembly layers are layered adjacently to each other (a plurality of metal-based particle assembly layers are preferably layered in such a manner that the layers are adjacent to each other with a spacer layer interposed therebetween). The arrangement of a plurality of metal-based particle assembly layers layered on each other produces interaction between single-layer-derived plasmons as well as interaction between plasmons that are excited in metal-based particle assembly layers respectively, which can accordingly increase the electric-field enhancement effect and the effect of extending the range in which the electric-field enhancement effect is exerted.

Note that there is a tendency that, for its nature, the effect of enhancing an electric-field by means of plasmon decreases as the distance between the active layer and the metal-based particle assembly layer increases. It is therefore preferable that the distance be smaller. The active layer and the metal-based particle assembly layer have a distance therebetween preferably of 100 nm or smaller, more preferably 20 nm or smaller, and still more preferably 10 nm or smaller.

Preferably the metal-based particle assembly layer has a plasmon peak with a maximum wavelength matching or close to the wavelength of excited light to be used and the absorption wavelength of the active layer. This allows plasmon resonance to contribute to a more effectively increased electric-field enhancement effect produced by plasmon. The maximum wavelength of the plasmon peak of the metal-based particle assembly layer is controllable by adjusting the layer's constituent metal-based particles in metal type, average particle diameter, average height, aspect ratio, and/or average interparticle distance.

Examples

Hereinafter, Examples will be described to more specifically describe the present invention, although the present invention is not limited thereto.

[Producing Metal-Based Particle Assembly Layer-Layered Substrate]

<Production Example 1>

A direct-current magnetron sputtering apparatus was used to grow silver particles significantly slowly on a soda glass substrate to form a thin film of a metal-based particle assembly on the entire surface of the substrate and thereby produce a metal-based particle assembly layer-layered substrate, under the following conditions:

gas used: argon;
pressure in chamber (sputtering-gas pressure): 10 Pa;
substrate-to-target distance: 100 mm;
sputtering power: 4 W;
average particle diameter growth rate (average particle diameter/sputtering time): 0.9 nm/minute;
average height growth rate (= average deposition rate = average height/sputtering time): 0.25 nm/minute;
substrate's temperature: 300°C; and
substrate's size and shape: a square with each side having a length of 5 cm.

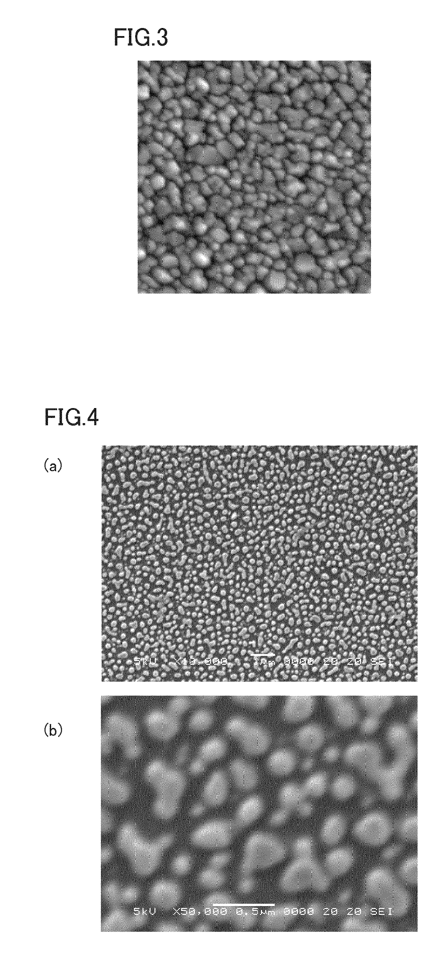

Fig. 2 is SEM images of a metal-based particle assembly layer in the obtained metal-based particle assembly layer-layered substrate, as observed from directly above. Fig. 2 (a) is an image enlarged as scaled 10000 times and Fig. 2 (b) is an image enlarged as scaled 50000 times. Fig. 3 is an AFM image of the metal-based particle assembly layer in the metal-based particle assembly layer-layered substrate obtained. The AFM image was obtained via "VN-8010" produced by KEYENCE CORPORATION (this is also applied hereinafter). Fig. 3 shows an image having a size of 5 $\mu$m x 5 $\mu$m.

A calculation with reference to the Fig. 2 SEM images indicates that the present production example provided a metal-based particle assembly layer configured of silver particles having an average particle diameter of 335 nm and an average interparticle distance of 16.7 nm, as based on the definition indicated above. Furthermore, from the Fig. 3 AFM image, an average height of 96.2 nm was obtained. From these values the silver particles' aspect ratio (average particle diameter/average height) was calculated to be 3.48 and it can also be found from the obtained images that the silver particles have an oblate shape. Furthermore, it can be seen from the SEM images that the metal-based particle assembly layer of this production example has approximately $6.25 \times 10^{10}$ silver particles (approximately 25 particles/$\mu$m$^2$).

Furthermore, the obtained metal-based particle assembly layer-layered substrate had the metal-based particle assembly layer connected at a surface to a tester (multimeter "E2378A" produced by Hewlett Packard Co.) to confirm conduction, and it has been found to be non-conductive.

<Production Example 2>

An aqueous silver nanoparticle dispersion (produced by Mitsubishi Paper Mills, Ltd., silver nanoparticle concentration: 25% by weight) was diluted with pure water to have a silver nanoparticle concentration of 2% by weight. Then to the aqueous silver nanoparticle dispersion 1% by volume of a surfactant was added and sufficiently agitated and thereafter to the obtained aqueous silver nanoparticle dispersion 80% by volume of acetone was added and sufficiently agitated at ordinary temperature to prepare a silver nanoparticle coating liquid.

Then, the silver nanoparticle coating liquid was applied with spin-coating at 1000 rpm on a 1 mm thick soda glass substrate having a surface wiped with acetone and thereafter the substrate was left as it was in the atmosphere for 1 minute and subsequently annealed in an electric furnace of 550°C for 40 seconds. A silver nanoparticle layer was thus formed, and on the nanoparticle layer the silver nanoparticle coating liquid was again applied with spin-coating at 1000 rpm and thereafter left as it was in the atmosphere for 1 minute and subsequently annealed in an electric furnace of 550°C for 40 seconds to obtain a metal-based particle assembly layer-layered substrate.

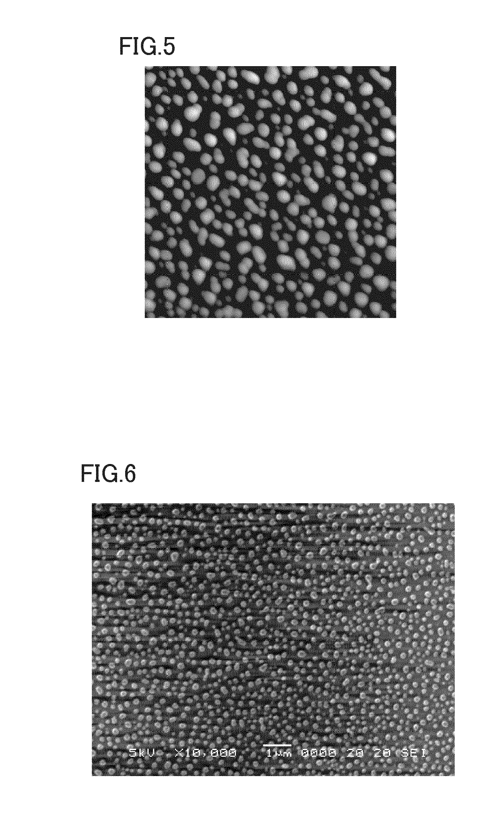

Fig. 4 is SEM images of a metal-based particle assembly layer in the obtained metal-based particle assembly layer-layered substrate, as observed from directly above. Fig. 4 (a) is an image enlarged as scaled 10000 times and Fig. 4 (b) is an image enlarged as scaled 50000 times. Fig. 5 is an AFM image of the metal-based particle assembly layer in the metal-based particle assembly layer-layered substrate obtained. Fig. 5 shows an image having a size of 5 $\mu$m x 5 $\mu$m.

A calculation with reference to the Fig. 4 SEM images indicates that the present production example provided a metal-based particle assembly layer configured of silver particles having an average particle diameter of 293 nm and an average interparticle distance of 107.8 nm, as based on the definition indicated above. Furthermore, from the Fig. 5 AFM image, an average height of 93.0 nm was obtained. From these values the silver particles' aspect ratio (average particle diameter/average height) was calculated to be 3.15 and it can also be found from the obtained images that the silver particles have an oblate shape. Furthermore, it can be seen from the SEM images that the metal-based particle assembly layer of this production example has approximately 3.13 x $10^{10}$ silver particles (approximately 12.5 particles/$\mu$m$^2$).

Furthermore, the obtained metal-based particle assembly layer-layered substrate had the metal-based particle assembly layer connected at a surface to a tester (multimeter "E2378A" produced by Hewlett Packard Co.) to confirm conduction, and it has been found to be non-conductive.

<Comparative Production Example 1>

An aqueous silver nanoparticle dispersion (produced by Mitsubishi Paper Mills, Ltd., silver nanoparticle concentration: 25% by weight) was diluted with pure water to have a silver nanoparticle concentration of 6% by weight. Then to the aqueous silver nanoparticle dispersion 1% by volume of a surfactant was added and sufficiently agitated and thereafter to the obtained aqueous silver nanoparticle dispersion 80% by volume of acetone was added and sufficiently shaken and thus mixed together at ordinary temperature to prepare a silver nanoparticle coating liquid.

Then, the silver nanoparticle coating liquid was applied with spin-coating at 1500 rpm on a 1 mm thick soda glass substrate having a surface wiped with acetone and thereafter the substrate was left as it was in the atmosphere for 1 minute and subsequently annealed in an electric furnace of 550°C for 5 minutes to obtain a metal-based particle assembly layer-layered substrate.

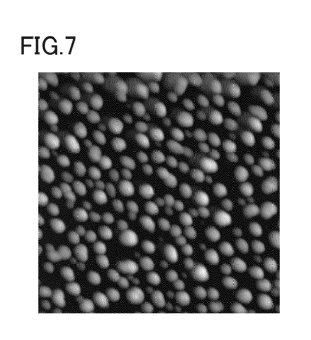

Fig. 6 is an SEM image, enlarged as scaled 10000 times, of the metal-based particle assembly layer in the metal-based particle assembly layer-layered substrate obtained in Comparative Production Example 1, as observed from directly above. Fig. 7 is an AFM image of the metal-based particle assembly layer in the metal-based particle assembly layer-layered substrate obtained in Comparative Production Example 1. Fig. 7 shows an image having a size of 5 $\mu$m x 5 $\mu$m.

A calculation with reference to the Fig. 6 SEM image indicates that Comparative Production Example 1 provided a metal-based particle assembly layer configured of silver particles having an average particle diameter of 278 nm and an average interparticle distance of 195.5 nm, as based on the definition indicated above. Furthermore, from the Fig. 7 AFM image, an average height of 99.5 nm was obtained. From these values the silver particle's aspect ratio (average particle diameter/average height) was calculated to be 2.79 and it can also be found from the obtained images that the silver particles have an oblate shape. Furthermore, it can be seen from the SEM image that the metal-based particle assembly layer of Comparative Production Example 1 has approximately 2.18 x $10^{10}$ silver particles (approximately 8.72 particles/$\mu$m$^2$).

[Measuring Absorption Spectrum of Metal-Based Particle Assembly Layer-Layered Substrate]

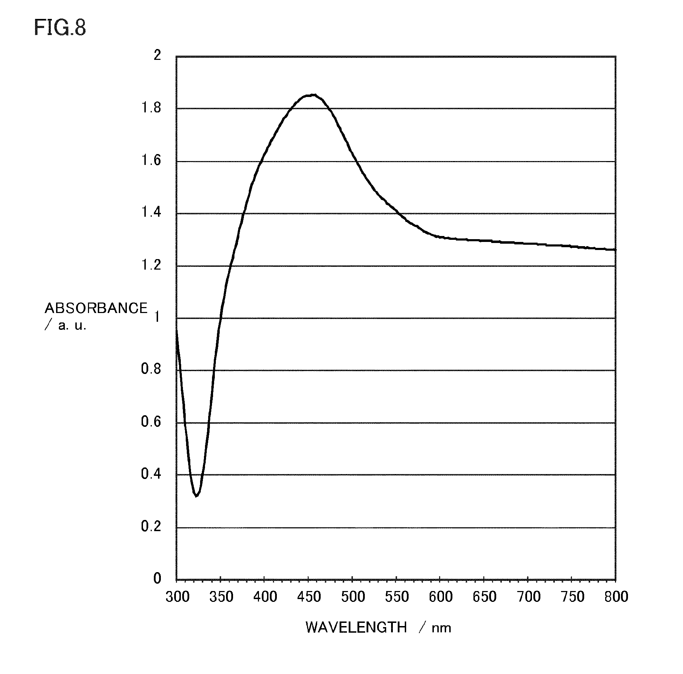

Fig. 8 represents absorption spectra, as measured through absorptiometry, of the metal-based particle assembly layer-layered substrates obtained in Production Example 1. As indicated in a nonpatent document (K. Lance Kelly, et al., "The Optical Properties of Metal Nanoparticles: The Influence of Size, Shape, and Dielectric Environment", The Journal of Physical Chemistry B, 2003, 107, 668), an oblate silver particle as produced in Production Example 1 typically has a plasmon peak around 550 nm and 650 nm for average particle diameters of 200 nm and 300 nm, respectively (these are both in the case of a sole silver particle).

In contrast, it can be seen that Production Example 1's metal-based particle assembly layer-layered substrate, with its constituent silver particles having an average particle diameter of approximately 300 nm (335 nm), nonetheless presents for a visible light region a maximum wavelength of a plasmon peak at a longest side in wavelength, and the maximum wavelength is around approximately 450 nm, or shifted to a shorter side in wavelength, as shown in Fig. 8. Furthermore, it presents, for the visible light region, a maximum wavelength of a plasmon peak at a longest side in wavelength, and an absorbance at the maximum wavelength is high, namely approximately 1.9. It can be seen therefrom that significantly intense plasmon resonance is presented.

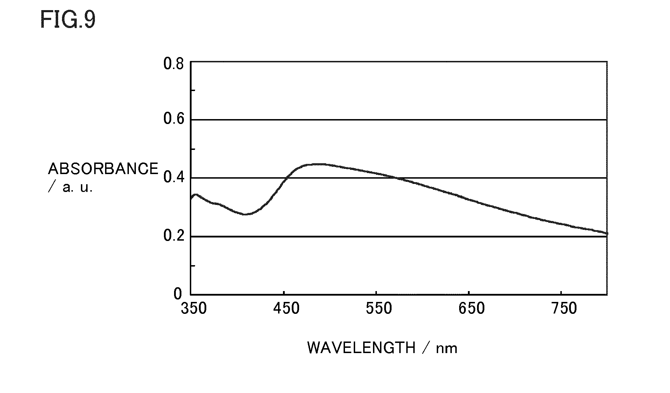

Fig. 9 represents an absorption spectrum, as measured through absorptiometry, of a metal-based particle assembly layer-layered substrate obtained in Production Example 2. It presented for the visible light region a maximum wavelength of a plasmon peak at a longest side in wavelength, and the maximum wavelength was 488 nm.

Note that the Figs. 8 and 9 absorption spectra are obtained as follows: a metal-based particle assembly layer-layered substrate is exposed to light of the ultraviolet to visible light region incident on a back surface thereof (i.e., a side opposite to the metal-based particle assembly layer) in a direction perpendicular to a substrate surface and intensity I of transmitted light omnidirectionally transmitted toward the metal-based particle assembly layer is measured with an integrating sphere spectrophotometer. On the other hand, a substrate which does not have a metal-based particle assembly film and has the same thickness and the same material as the substrate of said metal-based particle assembly film-layered substrate is exposed at a surface thereof to the same incident light as above in a direction perpendicular to that surface and intensity $I_0$ of transmitted light omnidirectionally transmitted through a side opposite to the incident surface is measured with the integrating sphere spectrophotometer. The axis of ordinate represents absorbance, which is represented by the following expression:

$$\text{Absorbance} = -\log_{10}(I/I_0).$$

[Producing Reference Metal-Based Particle Assembly and Measuring Absorption Spectrum]

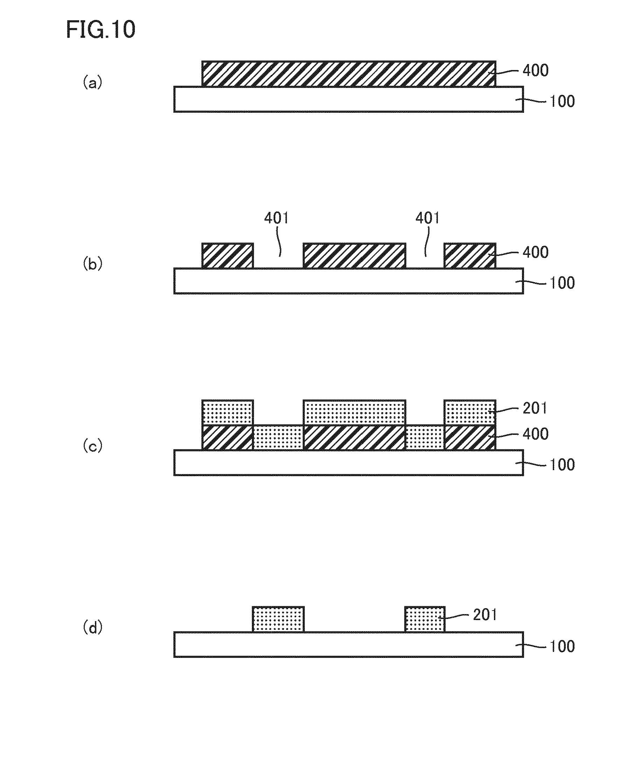

A method shown in Fig. 10 was used to produce a substrate having a reference metal-based particle assembly layered thereon. Initially, resist (ZEP520A produced by Nippon Zeon Co., Ltd.) was applied with spin-coating substantially on an entire surface of a 5 cm long and 5 cm wide soda glass substrate 100 (Fig. 10 (a)). Resist 400 had a thickness of approximately 120 nm. Then electron beam lithography was employed to provide resist 400 with a circular opening 401 (Fig. 10 (b)). Circular opening 401 had a diameter of approximately 350 nm. Furthermore, adjacent circular openings 401 had a center-to-center distance of approximately 1500 nm.

Subsequently, resist 400 having circular opening 401 was subjected to vacuum deposition to have a silver film 201 deposited thereon (Fig. 10 (c)). Silver film 201 had a thickness of approximately 100 nm. Finally, the substrate having silver film 201 was immersed in NMP (N-methyl-2-pyrrolidone produced by Tokyo Chemical Industry Co,. Ltd.), and settled in an ultrasonic device for one minute at room temperature to peel off resist 400 and silver film 201 deposited on resist 400, thereby obtaining a reference metal-based particle assembly layer-layered substrate in which only the silver film 201 (silver particles) in circular opening 401 was left and layered on soda glass substrate 100 (Fig. 10 (d)).

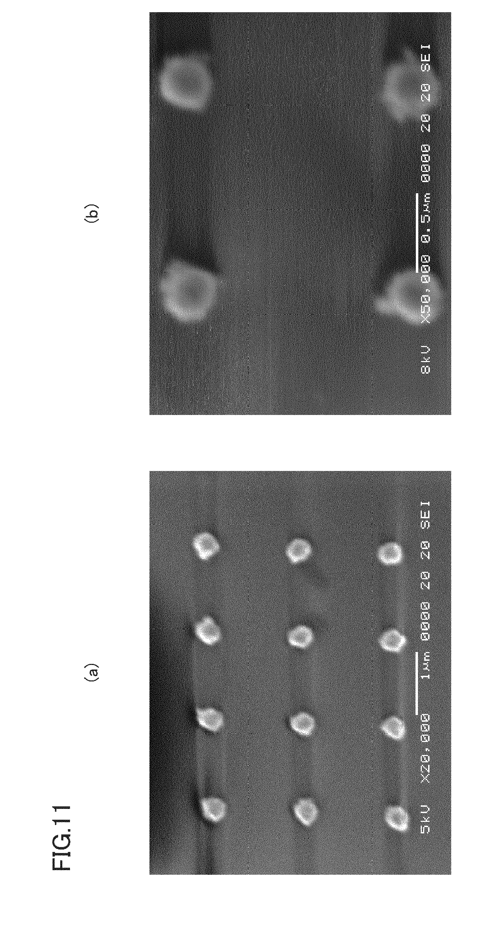

Fig. 11 is SEM images of a reference metal-based particle assembly layer in the obtained reference metal-based particle assembly layer-layered substrate, as observed from directly above. Fig. 11 (a) is an image enlarged as scaled 20000 times and Fig. 11 (b) is an image enlarged as scaled 50000 times. A calculation with reference to the Fig. 11 SEM images indicates that the reference metal-based particle assembly layer was configured of silver particles having an average particle diameter of 333 nm and an average interparticle distance of 1264 nm, as based on the definition indicated above. Furthermore, from a separately obtained AFM image, an average height of 105.9 nm was obtained. Furthermore, from the SEM images, it has been found that the reference metal-based particle assembly had approximately 62500 silver particles.

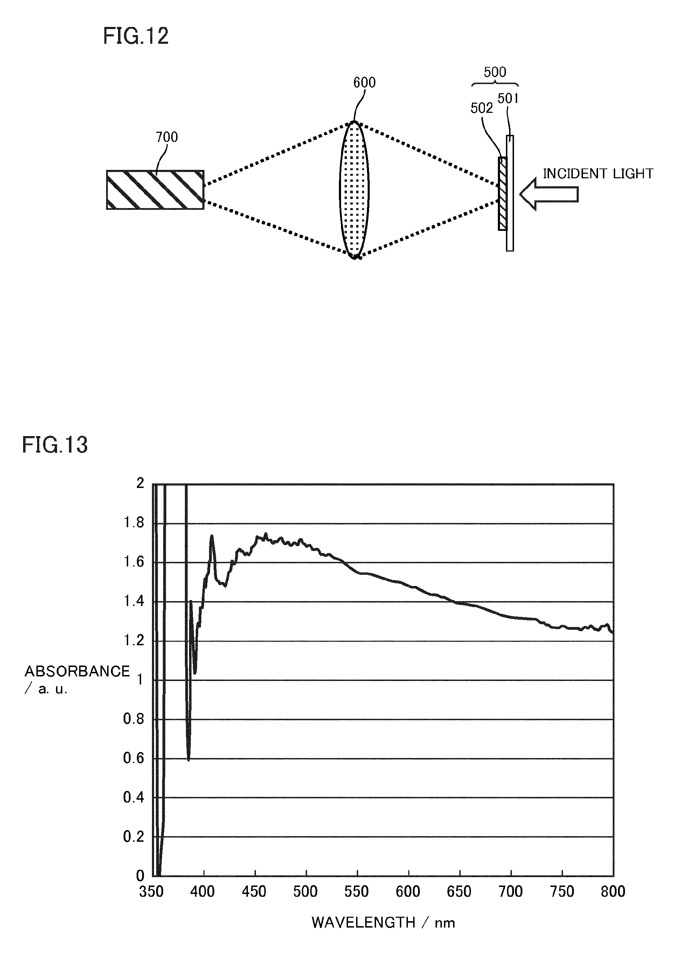

In accordance with the above described measurement method using a microscope's objective lens (100 times), absorption spectrum measurement was performed for the metal-based particle assembly layer-layered substrate of Production Example 1. More specifically, with reference to Fig. 12, a metal-based particle assembly layer-layered substrate 500 had a substrate 501 exposed at a side thereof (a side opposite to a metal-based particle assembly layer 502) to light of a visible light region incident thereon in a direction perpendicular to a substrate surface. The transmitted light that was transmitted to a side of metal-based particle assembly layer 502 and reached an objective lens 600 of 100 times was condensed by objective lens 600 and detected via a spectrophotometer 700 to obtain an absorption spectrum.

For spectrophotometer 700 was used "MCPD-3000", a spectrophotometer produced by Otsuka Electronics Co., Ltd. for an ultraviolet and visible region, and for objective lens 600 was used "BD Plan 100/0.80 ELWD" produced by Nikon. The result is shown in Fig. 13. A plasmon peak at a longest side in wavelength for the visible light region had a maximum wavelength similar to that shown in the Fig. 8 absorption spectrum, i.e., approximately 450 nm. In contrast, when absorption spectrum measurement was performed for the reference metal-based particle assembly layer-layered substrate also in accordance with the measurement method using the microscope's objective lens, it presented for the visible light region a maximum wavelength of a peak at a longest side in wavelength, and the maximum wavelength was 654 nm. Production Example 1's metal-based particle assembly layer-layered substrate presents for the visible light region a maximum wavelength of a peak at a longest side in wavelength, and the maximum wavelength is blue-shifted by approximately 200 nm as compared with that of the reference metal-based particle assembly layer-layered substrate.

The metal-based particle assembly layer-layered substrate of Production Example 1 presented for the visible light region a maximum wavelength of a peak at a longest side in wavelength, and an absorbance at the maximum wavelength was 1.744 (Fig. 13), whereas the reference metal-based particle assembly layer-layered substrate presented an absorbance of 0.033. As the metal-based particle assembly layer-layered substrate of Production Example 1 and the reference metal-based particle assembly layer-layered substrate were examined to compare the absorbances at the maximum wavelengths of their peaks at a longest side in wavelength, they were compared for the same number of metal-based particles, and to do so, an absorbance obtained from an absorption spectrum was divided by a parameter corresponding to the number of metal-based particles, i.e., a coverage of a substrate's surface by the metal-based particles, to calculate absorbance/coverage. The metal-based particle assembly layer-layered substrate of Production Example 1 presented absorbance/coverage of 2.04 (coverage: 85.3%), whereas the reference metal-based particle assembly layer-layered substrate presented absorbance/coverage of 0.84 (coverage: 3.9%).

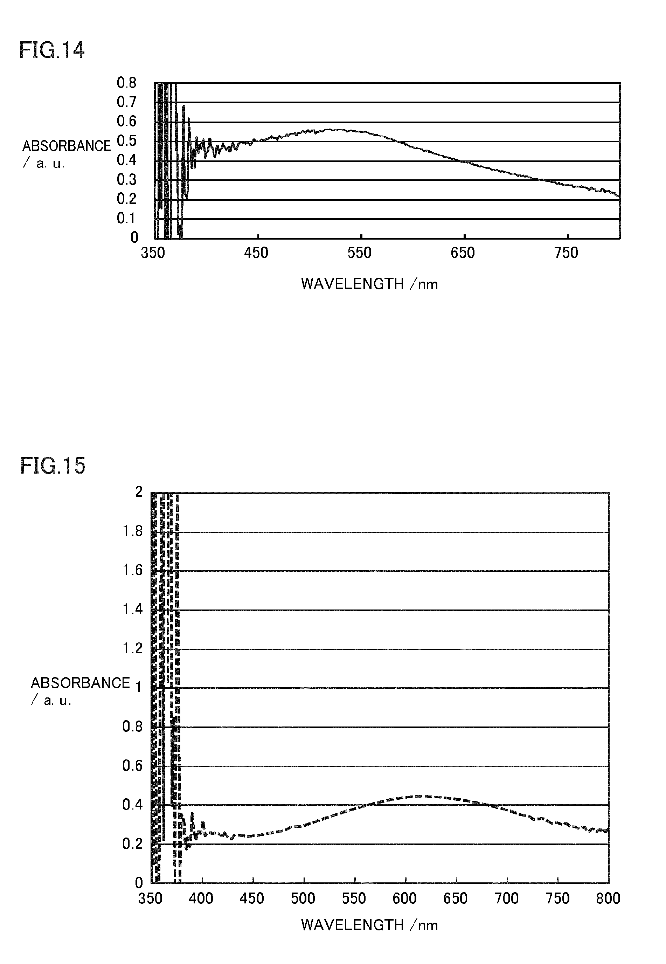

Figs. 14 and 15 are absorption spectra of the metal-based particle assembly layer-layered substrates obtained in Production Example 2 and Comparative Production Example 1, respectively, as measured by a method using an objective lens (100 times) of a microscope. The metal-based particle assembly layer-layered substrate obtained in Comparative Production Example 1 presented for the visible light region a maximum wavelength of a peak at a longest side in wavelength, and the maximum wavelength was 611 nm. This maximum wavelength is substantially the same as that of the reference metal-based particle assembly film-layered substrate corresponding to the metal-based particle assembly film-layered substrate of Comparative Production Example 1, and the metal-based particle assembly film of Comparative Production Example 1 substantially does not show a blue shift. The Fig. 15 absorption spectrum provides for the visible light region a maximum wavelength of a peak at a longest side in wavelength, and an absorbance at the maximum wavelength is 0.444 and the metal-based particles cover the substrate's surface at a coverage of 53.2%, and therefrom absorbance/coverage of 0.83 is calculated. This absorbance/coverage is smaller than that of the reference metal-based particle assembly layer-layered substrate.

The metal-based particle assembly of Production Example 2 has metal-based particles having a larger average particle diameter than that of Comparative Production Example 1, and accordingly it is rationally inferred from the Mie-scattering theory that the metal-based particle assembly of Production Example 2 presents a plasmon peak appearing at a longer side in wavelength than that of Comparative Production Example 1. In reality, however, the metal-based particle assembly of Production Example 2 has presented a plasmon peak at a shorter side in wavelength than that of Comparative Production Example 1 by as much as 100 nm or larger. This rationally indicates that the metal-based particle assembly of Production Example 2 presents a plasmon peak with a maximum wavelength shifted toward a shorter side in wavelength than the reference metal-based particle assembly in a range of from 30 to 500 nm.

[Producing Photoelectric Conversion Device and Assessing Current

Characteristics]

<Example 1>

Silver particles were grown under similar conditions to Production Example 1 to provide on a 0.5 mm thick soda glass substrate a metal-based particle assembly layer identical to that described in Production Example 1, except that the average height was 79.9 nm. Thereafter immediately a spin-on glass (SOG) solution was applied with spin-coating on the metal-based particle assembly layer to have an insulating layer having an average thickness of 80 nm layered thereon. For the SOG solution was used "OCD T-7 5500T", an organic SOG material produced by TOKYO OHKA KOGYO CO., LTD., which was then diluted with ethanol.

Then ion sputtering was employed to layer an anode electrode that is an IZO layer (thickness: 22 nm) on the insulating layer and thereafter a hole transport layer forming solution was applied on the anode electrode by spin coating to layer a hole transport layer having an average thickness of 20 nm. For the hole transport layer forming solution was used a product of PLEXTRONICS Inc. having a product name "Plexcore AQ 1200" which was then diluted with ethanol to have a prescribed concentration. The insulating layer, the anode electrode, and the hole transport layer have a total average thickness of 122 nm (i.e., an average distance from a surface of the metal-based particle assembly film to a light emitting layer).

Subsequently, a solution for a light absorption layer was applied with spin-coating and subjected to heat treatment with a hot plate at 150°C for 15 minutes to thereby form the light absorption layer having an average thickness of 50 nm. The solution for the light absorption layer was prepared by dissolving 30 mg of P3HT (produced by Sigma-Aldrich Co. LLC.) and 24 mg of PCBM (produced by Sigma-Aldrich Co. LLC.) in 3 mL of chlorobenzene. After this, vacuum deposition was used to deposit, on the light absorption layer, an NaF layer (2 nm in thickness) to serve as a buffer layer, and an Mg layer (2 nm in thickness) and an Ag layer (10 nm in thickness) to serve as a cathode electrode in this order. The obtained device had a front surface sealed with a sealant ("XNR5516ZLV", a UV curable resin produced by Nagase

Chemtex Corp.) to obtain a photoelectric conversion device.

<Comparative Example 1>

A photoelectric conversion device was produced similarly to Example 1, except that the metal-based particle assembly layer was not formed.

To the photoelectric conversion device of Example 1, a voltage/current generator ("R6240A" produced by Advantest Corporation) was connected with 0 V applied across electrodes. As background current $I_0$, the value of current measured at this time before irradiation with light was used. Next, to the photoelectric conversion device, light perpendicular to the cathode electrode surface of the device was applied from the cathode-electrode-side of the device by means of a halogen lamp ("MHAB-150W" produced by Schott Moritex Corporation), and current value $I_1$ flowing at this time was measured. Background current $I_0$ was subtracted from current value $I_1$ to determine current value $I_2$ of the

photoelectric conversion device of Example 1. In a similar manner to that for the photoelectric conversion device of Example 1, current value $I_2$ of the photoelectric conversion device of Comparative Example 1 was also determined. It has thus been confirmed that the photoelectric conversion device of Example 1 has current value $I_2$ which is about 17.4 times as high as that of the photoelectric conversion device of Comparative Example 1.

REFERENCE SIGNS LIST

10: substrate; 20: metal-based particle; 30: insulating layer; 40: first electrode layer; 50: active layer (light absorption layer); 60: second electrode layer; 100: soda glass substrate; 201: silver film; 400: resist; 401: circular opening; 500: metal-based particle assembly layer-layered substrate; 501: substrate; 502: metal-based particle assembly layer; 600: objective lens; 700: spectrophotometer

**Claims**

1. A photoelectric conversion device comprising:

    an active layer; and
    a metal-based particle assembly layer consisting of a particle assembly including 30 or more metal-based particles separated from each other and disposed in two dimensions, said metal-based particles having an average particle diameter in a range of from 10 to 1600 nm, an average height in a range of from 5 to 500 nm, and an aspect ratio, as defined by a ratio of said average particle diameter to said average height, in a range of from 0.5 to 8, wherein
    said metal-based particles that compose said metal-based particle assembly layer are disposed such that an average distance between adjacent metal-based particles may be in a range of from 1 to 150 nm.

2. A photoelectric conversion device comprising:

    an active layer; and
    a metal-based particle assembly layer consisting of a particle assembly including 30 or more metal-based particles separated from each other and disposed in two dimensions, said metal-based particles having an average particle diameter in a range of from 10 to 1600 nm, an average height in a range of from 5 to 500 nm, and an aspect ratio, as defined by a ratio of said average particle diameter to said average height, in a range of from 0.5 to 8, wherein
    said metal-based particle assembly layer has in an absorption spectrum for a visible light region a maximum wavelength of a peak at a longest side in wavelength, and the maximum wavelength shifts toward a shorter side in wavelength in a range of from 30 to 500 nm as compared with that of a reference metal-based particle assembly in which metal-based particles having a particle diameter equal to said average particle diameter and a height equal to said average height and made of the same material are disposed such that each distance between adjacent metal-based particles may be in a range of from 1 to 2 $\mu$m.

3. A photoelectric conversion device comprising:

    an active layer; and
    a metal-based particle assembly layer consisting of a particle assembly including 30 or more metal-based particles separated from each other and disposed in two dimensions, said metal-based particles having an average particle diameter in a range of from 10 to 1600 nm, an average height in a range of from 5 to 500 nm, and an aspect ratio, as defined by a ratio of said average particle diameter to said average height, in a range of from 0.5 to 8, wherein
    said metal-based particle assembly layer has in an absorption spectrum for a visible light region a maximum wavelength of a peak at a longest side in wavelength, and an absorbance at the maximum wavelength is higher as compared with that of a reference metal-based particle assembly in which metal-based particles having a particle diameter equal to said average particle diameter and a height equal to said average height and made of the same material are disposed such that each distance between adjacent metal-based particles may be in a range of from 1 to 2 $\mu$m, on the premise that the numbers of the metal-based particles are the same.

4. The photoelectric conversion device according to any one of claims 1 to 3, comprising more than one said metal-based particle assembly layer.

5. The photoelectric conversion device according to any one of claims 1 to 3, wherein said metal-based particles that compose the metal-based particle assembly layer are non-conductive between adjacent metal-based particles.

6. The photoelectric conversion device according to any one of claims 1 to 3, wherein said metal-based particle assembly layer has in an absorption spectrum for a visible light region a maximum wavelength of a peak at a longest side in wavelength, and the maximum wavelength is in a range of from 350 to 550 nm.

7. The photoelectric conversion device according to any one of claims 1 to 3, wherein said metal-based particle assembly layer has in an absorption spectrum for a visible light region a maximum wavelength of a peak at a longest side in wavelength, and an absorbance at the maximum wavelength is at least one.

8. The photoelectric conversion device according to any one of claims 1 to 3, wherein said active layer has a thickness of 10 nm or more.

9. The photoelectric conversion device according to any one of claims 1 to 3, wherein said photoelectric conversion device is an organic thin-film solar cell.

10. A method of improving conversion efficiency of a photoelectric conversion device, the method comprising disposing in said photoelectric conversion device a metal-based particle assembly layer consisting of a particle assembly including 30 or more metal-based particles separated from each other and disposed in two dimensions, said metal-based particles having an average particle diameter in a range of from 10 to 1600 nm, an average height in a range of from 5 to 500 nm, and an aspect ratio, as defined by a ratio of said average particle diameter to said average height, in a range of from 0.5 to 8, wherein
said metal-based particles are disposed such that an average distance between adjacent metal-based particles may be in a range of from 1 to 150 nm.

11. A method of improving conversion efficiency of a photoelectric conversion device, the method comprising disposing in said photoelectric conversion device a metal-based particle assembly layer consisting of a particle assembly including 30 or more metal-based particles separated from each other and disposed in two dimensions, said metal-based particles having an average particle diameter in a range of from 10 to 1600 nm, an average height in a range of from 5 to 500 nm, and an aspect ratio, as defined by a ratio of said average particle diameter to said average height, in a range of from 0.5 to 8, wherein
said metal-based particle assembly layer has in an absorption spectrum for a visible light region a maximum wavelength of a peak at a longest side in wavelength, and the maximum wavelength shifts toward a shorter side in wavelength in a range of from 30 to 500 nm as compared with that of a reference metal-based particle assembly in which metal-based particles having a particle diameter equal to said average particle diameter and a height equal to said average height and made of the same material are disposed such that each distance between adjacent metal-based particles may be in a range of from 1 to 2 $\mu$m.

12. A method of improving conversion efficiency of a photoelectric conversion device, the method comprising disposing in said photoelectric conversion device a metal-based particle assembly layer consisting of a particle assembly including 30 or more metal-based particles separated from each other and disposed in two dimensions, said metal-based particles having an average particle diameter in a range of from 10 to 1600 nm, an average height in a range of from 5 to 500 nm, and an aspect ratio, as defined by a ratio of said average particle diameter to said average height, in a range of from 0.5 to 8, wherein
said metal-based particle assembly layer has in an absorption spectrum for a visible light region a maximum wavelength of a peak at a longest side in wavelength, and an absorbance at the maximum wavelength is higher as compared with that of a reference metal-based particle assembly in which metal-based particles having a particle diameter equal to said average particle diameter and a height equal to said average height and made of the same material are disposed such that each distance between adjacent metal-based particles may be in a range of from 1 to 2 $\mu$m, on the premise that the numbers of the metal-based particles are the same.

FIG.1

FIG.2

(a)

(b)

ENLARGED

FIG.3

FIG.4

(a)

(b)

FIG.5

FIG.6

FIG.7

FIG.8

FIG.9

WAVELENGTH / nm

FIG.10

(a)

400
100

(b)

401      401
400
100

(c)

201
400
100

(d)

201
100

FIG.11

(a)

(b)

FIG.12

FIG.13

FIG.14

FIG.15

## INTERNATIONAL SEARCH REPORT

| International application No. |
| --- |
| PCT/JP2012/077095 |

A.  CLASSIFICATION OF SUBJECT MATTER
*H01L31/04*(2006.01)i

According to International Patent Classification (IPC) or to both national classification and IPC

B.  FIELDS SEARCHED

Minimum documentation searched (classification system followed by classification symbols)
H01L31/04-31/078, 51/42-51/48

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
JSTPlus(JDreamII), JST7580(JDreamII)

C.  DOCUMENTS CONSIDERED TO BE RELEVANT

| Category* | Citation of document, with indication, where appropriate, of the relevant passages | Relevant to claim No. |
| --- | --- | --- |
| X | WO 2011/125101 A1 (Toshiba Corp.), 13 October 2011 (13.10.2011), paragraphs [0015] to [0183]; fig. 1 to 17 (Family: none) | 1-12 |
| X | W. Liu et al., Surface plasmon enhanced GaAs thin film solar cells, SOLAR ENERGY MATERIALS & SOLAR CELLS, 2010.10.27, Vol.95, pp.693-698 | 1-12 |
| P,X | WO 2012/042831 A1 (JX Nippon Oil & Energy Corp.), 05 April 2012 (05.04.2012), paragraphs [0040] to [0077]; fig. 1 to 5 & JP 2012-74569 A | 1-12 |

☒  Further documents are listed in the continuation of Box C.  ☐  See patent family annex.

| | |
| --- | --- |
| *  Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| 05 November, 2012 (05.11.12) | 20 November, 2012 (20.11.12) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**INTERNATIONAL SEARCH REPORT**

International application No.

PCT/JP2012/077095

C (Continuation).   DOCUMENTS CONSIDERED TO BE RELEVANT

| Category* | Citation of document, with indication, where appropriate, of the relevant passages | Relevant to claim No. |
|---|---|---|
| P,X | WO 2012/133778 A1  (Sumitomo Chemical Co., Ltd.), 04 October 2012 (04.10.2012), entire text; all drawings (Family: none) | 1-12 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007139540 A
- WO 2006085515 A
- JP 2007335222 A

**Non-patent literature cited in the description**

- **T. FUKUURA ; M. KAWASAKI.** Long Range Enhancement of Molecular Fluorescence by Closely Packed Submicro-scale Ag Islands. *e-Journal of Surface Science and Nanotechnology,* 2009, vol. 7, 653
- Particle Measurement Technique. Nikkan Kogyo Shimbun, Ltd, 1994, 5
- **K. LANCE KELLY et al.** The Optical Properties of Metal Nanoparticles: The Influence of Size, Shape, and Dielectric Environment. *The Journal of Physical Chemistry B,* 2003, vol. 107, 668